(19) Europäisches Patentamt
European Patent Office
Office européen des brevets

(11) **EP 4 529 057 A1**

(12) **EUROPEAN PATENT APPLICATION**
published in accordance with Art. 153(4) EPC

(43) Date of publication:
**26.03.2025 Bulletin 2025/13**

(21) Application number: **23806678.1**

(22) Date of filing: **19.04.2023**

(51) International Patent Classification (IPC):
**H04L 1/00** (2006.01)

(52) Cooperative Patent Classification (CPC):
**H04L 1/00**

(86) International application number:
**PCT/CN2023/089309**

(87) International publication number:
**WO 2023/221725 (23.11.2023 Gazette 2023/47)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **20.05.2022 CN 202210550053**

(71) Applicant: **ZTE Corporation
Shenzhen, Guangdong 518057 (CN)**

(72) Inventors:
• **ZHAO, Wei
Shenzhen, Guangdong 518057 (CN)**

• **XU, Jin
Shenzhen, Guangdong 518057 (CN)**
• **LI, Liguang
Shenzhen, Guangdong 518057 (CN)**
• **LIANG, Chulong
Shenzhen, Guangdong 518057 (CN)**
• **XUE, Yan
Shenzhen, Guangdong 518057 (CN)**
• **XIE, Feng
Shenzhen, Guangdong 518057 (CN)**

(74) Representative: **Savi, Massimiliano
Notarbartolo & Gervasi S.p.A.
Viale Achille Papa, 30
20149 Milano (IT)**

(54) **DATA PROCESSING METHOD, ELECTRONIC DEVICE, AND COMPUTER READABLE STORAGE MEDIUM**

(57) The present application discloses a data processing method, an electronic device, and a storage medium. The data processing method comprises: under the condition that at least one source data packet is obtained, determining a first network coding mode for the source data packet according to a preconfigured first network coding parameter; coding the source data packet according to the first network coding mode to obtain a first coded data packet; and sending the first coded data packet to a first receiving end, so that the first receiving end processes the first coded data packet.

```
┌────────────────────────────────────────────────────┐
│ Determine, when at least one source data packet is  │      S110
│ acquired, a first network coding mode for the at    │
│ least one source data packet according to a         │
│ pre-configured first network coding parameter       │
└────────────────────────────────────────────────────┘
                         │
                         ▼
┌────────────────────────────────────────────────────┐
│ Encode the at least one source data packet          │      S120
│ according to the first network coding mode to       │
│ obtain a first encoded data packet                  │
└────────────────────────────────────────────────────┘
                         │
                         ▼
┌────────────────────────────────────────────────────┐
│ Send the first encoded data packet to a first       │      S130
│ receiving end, such that the first receiving end    │
│ processes the first encoded data packet             │
└────────────────────────────────────────────────────┘
```

FIG. 3

**Description**

**CROSS-REFERENCE TO RELATED APPLICATION**

This application is filed on the basis of Chinese patent application No. 202210550053.5 filed May 20, 2022, and claims priority to the Chinese patent application, the entire contents of which are incorporated herein by reference.

**TECHNICAL FIELD**

The present disclosure relates to the technical field of communication, and more particularly, to a data processing method, an electronic device, and a computer-readable storage medium.

**BACKGROUND**

According to the 5th Generation (5G) Technical Specification (TS) of the 3rd Generation Partnership Project (3GPP), there are two retransmission mechanisms in the L2 of New Radio (NR): Hybrid Automatic Repeat Request (HARQ) in the Media Access Control (MAC) layer and Automatic Repeat-reQuest (ARQ) in the Radio Link Control (RLC) layer. To improve the reliability of data transmission, the Packet Data Convergence Protocol (PDCP) layer in L2 employs PDCP repetition, which involves repeatedly sending data packets. Although PDCP repetition can enhance reliability in Ultra Reliable Low Latency Communication (URLLC) scenarios, it is constrained by physical resource overheads, and can only be applied to small data packets. Moreover, the repeated transmission of data packets results in excessive consumption of physical resources.

**SUMMARY**

Embodiments of the present disclosure provide a data processing method, an electronic device, and a computer-readable storage medium, to improve the reliability and throughput of data transmission while reducing physical resource overheads.

In accordance with a first aspect of the present disclosure, an embodiment provides a data processing method, including:

determining, in response to acquiring at least one source data packet, a first network coding mode for the at least one source data packet according to a pre-configured first network coding parameter,

encoding the at least one source data packet according to the first network coding mode to obtain a first encoded data packet; and

sending the first encoded data packet to a first receiving end, such that the first receiving end processes the first encoded data packet.

In accordance with a second aspect of the present disclosure, an embodiment provides a data processing method, including:

receiving a first encoded data packet sent by a transmitting end, where the first encoded data packet is obtained by the transmitting end by encoding acquired at least one source data packet according to a first network coding mode for the source data packet, and the first network coding mode is determined by the transmitting end according to a pre-configured first network coding parameter; and

processing the first encoded data packet.

In accordance with a third aspect of the present disclosure, an embodiment of the present disclosure provides an electronic device, including: at least one processor; and at least one memory, configured for storing at least one program, where the at least one program, when executed by the at least one processor, causes the at least one processor to implement the data processing method described above.

In accordance with a fourth aspect of the present disclosure, an embodiment provides a computer-readable storage medium, storing a processor-executable program which, when executed by a processor, causes the processor to implement the data processing method described above.

In the embodiments of the present disclosure, a transmitting end determines a first network coding mode for a source data packet according to a pre-configured first network coding parameter, performs network coding on the source data packet based on the determined first network coding mode to generate encoded data, and transmits the encoded data to a first receiving end, such that the first receiving end receives sufficient encoded data for processing. That is to say, the transmitting end only needs to send the corresponding encoded data to the first receiving end, and the first receiving end can effectively complete the decoding. Therefore, the delay caused by repeated sending of data packets can be avoided, and the reliability and throughput of data transmission can be improved while reducing physical resource overheads, thereby filling in the technical gap in related methods.

**BRIEF DESCRIPTION OF DRAWINGS**

FIG. 1 is a schematic diagram of an implementation environment configured for executing a data processing method according to an embodiment of the present disclosure;

FIG. 2 is a schematic diagram of an implementation environment configured for executing a data processing method according to another embodiment of the present disclosure;

FIG. 3 is a flowchart of a data processing method according to an embodiment of the present disclosure;

FIG. 4 is a flowchart of steps S1200 to S1202 of a data processing method according to an embodiment of the present disclosure;

FIG. 5 is a schematic diagram illustrating the principle of steps S1200 to S1202 according to an embodiment of the present disclosure;

FIG. 6 is a flowchart of steps S1203 to S1204 of a data processing method according to an embodiment of the present disclosure;

FIG. 7 is a schematic diagram illustrating the principle of steps S1203 to S1204 according to an embodiment of the present disclosure;

FIG. 8 is a schematic diagram illustrating the principle of S1205 according to an embodiment of the present disclosure;

FIG. 9 is a schematic diagram illustrating the principle of S1205 according to another embodiment of the present disclosure;

FIG. 10 is a schematic diagram illustrating the principle of S1206 according to an embodiment of the present disclosure;

FIG. 11 is a flowchart of steps S1207 to S1208 of a data processing method according to an embodiment of the present disclosure;

FIG. 12 is a schematic diagram illustrating the principle of steps S1207 to S1208 according to an embodiment of the present disclosure;

FIG. 13 is a flowchart of steps S1209 to S1210 of a data processing method according to an embodiment of the present disclosure;

FIG. 14 is a schematic diagram illustrating the principle of steps S1209 to S1210 according to an embodiment of the present disclosure;

FIG. 15 is a schematic diagram illustrating the principle of S1101 according to an embodiment of the present disclosure;

FIG. 16 is a schematic diagram illustrating the principle of S1105 according to an embodiment of the present disclosure;

FIG. 17 is a schematic diagram illustrating the principle of a data processing method when the first network coding parameter includes a code rate and quantity information of the source data packet according to an embodiment of the present disclosure;

FIG. 18 is a schematic diagram illustrating the principle of a data processing method when the first network coding parameter includes a code rate and quantity information of the source data packet according to another embodiment of the present disclosure;

FIG. 19 is a schematic diagram illustrating the principle of S1108 according to an embodiment of the present disclosure;

FIG. 20 is a schematic diagram illustrating the principle of S1109 according to an embodiment of the present disclosure;

FIG. 21 is a schematic diagram illustrating the principle of S1110 according to an embodiment of the present disclosure;

FIG. 22 is a flowchart of steps S1111 to S1112 of a data processing method according to an embodiment of the present disclosure;

FIG. 23 is a schematic diagram illustrating the principle of a data processing method when the source data packet is a PDCP Service Data Unit (SDU) data packet according to an embodiment of the present disclosure;

FIG. 24 is a schematic diagram illustrating the principle of a data processing method when the source data packet is a PDCP SDU data packet according to another embodiment of the present disclosure;

FIG. 25 is a schematic diagram illustrating the principle of a data processing method when the source data packet is a PDCP SDU data packet according to another embodiment of the present disclosure;

FIG. 26 is a schematic diagram illustrating the principle of a data processing method when the source data packet is a PDCP Protocol Data Unit (PDU) data packet according to an embodiment of the present disclosure;

FIG. 27 is a schematic diagram illustrating the principle of a data processing method when the source data packet is an RLC SDU data packet according to an embodiment of the present disclosure;

FIG. 28 is a schematic diagram illustrating the principle of a data processing method when the source data packet is an RLC SDU data packet according to another embodiment of the present disclosure;

FIG. 29 is a schematic diagram illustrating the principle of a data processing method when the source data packet is an RLC PDU data packet according to an embodiment of the present disclosure;

FIG. 30 is a schematic diagram illustrating the principle of a data processing method when the source data packet is a MAC SDU data packet according to an embodiment of the present disclosure;

FIG. 31 is a schematic diagram illustrating the principle of a data processing method when the source data packet is a MAC PDU data packet according to an embodiment of the present disclosure;

FIG. 32 is a flowchart of a data processing method according to another embodiment of the present disclosure;

FIG. 33 is a flowchart of processing a first encoded data packet in a data processing method according to an embodiment of the present disclosure; and

FIG. 34 is a schematic diagram of an electronic device according to an embodiment of the present disclosure.

## DETAILED DESCRIPTION

To make the objects, technical schemes, and advantages of the present disclosure clear, it is described in further detail with the accompanying drawings and examples. It should be understood that the specific embodiments described herein are provided merely for illustrative purposes and are not intended to limit the scope of the disclosure.

It is also noted that, although logical orders are presented in the flowcharts, the steps shown or described may, in some cases, be executed in an order different from that shown. The terms such as "first," "second," and similar terms in the description, claims, and accompanying drawings are used to distinguish between similar objects and do not necessarily indicate a specific sequence or precedence.

The present disclosure provides a data processing method, an electronic device, and a computer-readable storage medium. In the data processing method of an embodiment, a transmitting end determines a first network coding mode for a source data packet according to a pre-configured first network coding parameter, performs network coding on the source data packet based on the determined first network coding mode to generate encoded data, and transmits the encoded data to a first receiving end, such that the first receiving end receives sufficient encoded data for processing. That is to say, the transmitting end only needs to send the corresponding encoded data to the first receiving end, and the first receiving end can effectively complete the decoding. Therefore, the delay caused by repeated sending of data packets can be avoided, and the reliability and throughput of data transmission can be improved while reducing physical resource overheads, thereby filling in the technical gap in related methods.

The embodiments of the present disclosure will be further described in detail below with reference to the accompanying drawings.

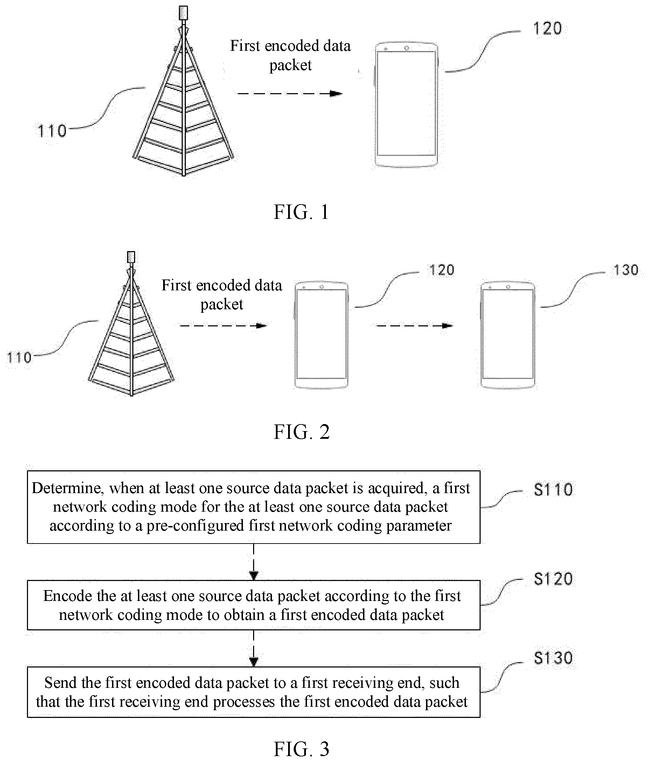

FIG. 1 is a schematic diagram of an implementation environment configured for executing a data processing method according to an embodiment of the present disclosure.

In the example of FIG. 1, the implementation environment includes, but not limited to, a transmitting end 110 and a first receiving end 120. The first receiving end 120 and the transmitting end 110 can send wireless signals to each other, receive wireless signals from each other, perform related interaction with each other, and so on.

In an embodiment, the relative positions, numbers, etc., of the first receiving end 120 and the transmitting end 110 may be set according to specific application scenarios. For example, the transmitting end 110 can radiate a signal to the outside, and the first receiving end 120 may move along a trajectory formed by the transmitting end 110 when radiating the signal to the outside. It can be understood that if there are a plurality of first receiving ends 120 and different first receiving ends 120 are arranged in the above manner, the wireless signal sent by the transmitting end 110 can be received at different spatial positions. It should be noted that the spatial positions may be different geographical locations.

In an example of FIG. 2, the implementation environment may further include, but not limited to, a second receiving end 130. The first receiving end 120 and the second receiving end 130 can send wireless signals to each other, receive wireless signals from each other, perform related interaction with each other, and so on.

In an embodiment, the number of second receiving ends 130 may be one or more, which is not limited and may be set by those having ordinary skills in the art according to requirements in actual application scenarios. In other words, the first receiving end 120 may interact with one second receiving end 130 individually or with a plurality of second receiving ends 130 respectively, which does not affect functional applications of the first receiving end 120.

In an implementation, the transmitting end 110, the first receiving end 120, or the second receiving end 130 may include, but not limited to, one of the following devices: a Base Station (BS), an Access Point (AP), a NodeB, a generalized Node B (g NodeB), a Radio Network Controller (RNC), an Evolved NodeB (eNB), a Base Station Controller (BSC), a Base Transceiver Station (BTS), a Transceiver Function (TF), a radio router, a radio transceiver, a Basic Service Set (BSS), an Extended Service Set (ESS), or a Radio Base Station (RBS), which is not particularly limited in this embodiment.

In an implementation, the transmitting end 110, the first receiving end 120, or the second receiving end 130 may be referred to as an access terminal device, a User Equipment (UE), a subscriber unit, a subscriber station, a mobile station, a remote station, a remote terminal device, a mobile device, a user terminal device, a wireless communication device, a user agent, or a user device. For example, the transmitting end 110 may be a cellular phone, a cordless telephone, a Session Initiation Protocol (SIP) telephone, a Wireless Local Loop (WLL) station, a Personal Digital Assistant (PDA), a handheld device with a wireless communication function, a computing device or other processing device connected to a wireless modem, a vehicle-mounted device, a wearable device, a terminal device in a 5G network or future evolved networks, etc., which is not limited in this embodiment.

In an embodiment, the implementation environment for executing the data processing method may be applied to, but not limited to, the 5G TS of the 3GPP. However, it can be understood that the development of future 6th Generation (6G) communication technologies have higher requirements on the data transmission rate, transmission delay, and data transmission reliability, and different application industries also have more refined requirements on the communication reliability, delay, and rate. Component-based design of Radio Interface Protocol stacks may become an important research direction. Enterprises can choose components according to their own requirements under the framework allowed by the Radio Interface Protocol stack to build a communication network that meets the requirements of enterprises. Network coding can also be used as an option in 6G technology in the form of components to improve the reliability and throughput of data transmission. That is to say, the implementation environment for executing the data processing method in this embodiment may also be applied, but not limited to, 6G communication or future-generation communication networks.

The transmitting end 110 has at least functions of determining a first network coding mode for a source data packet according to a pre-configured first network coding parameter, encodes the source data packet according to the first network coding mode to obtain a first encoded data packet, and sending the first encoded data packet to the first receiving end 120.

The first receiving end 120 has at least functions of receiving the first encoded data packet sent by the transmitting end 110 and processing the first encoded data packet. The first encoded data packet is obtained by the transmitting end 110 by encoding the source data packet according to the first network coding mode for the source data packet, and the first network coding mode is determined by the transmitting end 110 according to the pre-configured first network coding parameter.

The second receiving end 130 has at least a function of receiving the first encoded data packet sent by the first receiving end 120 or receiving a third encoded data packet sent by the first receiving end 120. The third encoded data packet is obtained by the first receiving end 120 by decoding the first encoded data packet to obtain the source data packet and encoding the source data packet.

In an embodiment, the above functions of the transmitting end 110, the first receiving end 120, or the second receiving end 130 may be applied to different application scenarios, which is not limited herein.

It can be understood by those having ordinary skills in the art that the implementation environment may be applied to 5G and 6G communication network systems, future evolved mobile communication network systems, etc., which is not particularly limited in this embodiment.

Those having ordinary skills in the art may understand that the implementation environments shown in FIG. 1 and FIG. 2 do not constitute a limitation to the embodiments of the present disclosure, and more or fewer components than those shown in the figure may be included, or some components may be combined, or a different component arrangement may be used.

Based on the above implementation environment, various embodiments of the data processing method of the present disclosure are proposed below.

FIG. 3 is a flowchart of a data processing method according to an embodiment of the present disclosure. The data processing method may include, but not limited to, the following steps S110 to S130.

At S110, when at least one source data packet is acquired, a first network coding mode for the at least one source data packet is determined according to a pre-configured first network coding parameter.

In an embodiment, the execution entity of the data processing method in this embodiment may be, but not limited to, the transmitting end 110 in the embodiment shown in FIG. 1 or FIG. 2, or those having ordinary skills in the art may set the corresponding execution entity according to actual application scenarios, which is not limited in this embodiment. To more conveniently describe the application scenarios and principle of the present disclosure, the following related embodiments are described with the transmitting end as the execution entity of the data processing method, which should not be construed as a limitation to the embodiments of the present disclosure.

In this step, the transmitting end determines the first network coding mode for the source data packet according to the pre-configured first network coding parameter, so as to perform network coding on the source data packet based on the first network coding mode to generate encoded data in subsequent steps.

In an embodiment, the source data packet includes at least one of:

a data packet of a PDCP sublayer in a Radio Interface Protocol stack;

a data packet of an RLC sublayer in a Radio Interface Protocol stack;

a data packet of a MAC sublayer in a Radio Interface Protocol stack; or

a data packet of a physical layer in a Radio Interface Protocol stack.

It can be understood that the source data packet may also be set according to specific application scenarios, which is not limited in this embodiment. Methods for acquiring the source data packet are well known to those having ordinary skills in the art, so the details will not be described herein. For example, the source data packet is acquired from a Radio Interface Protocol stack.

In an embodiment, when there is network coding in a plurality of Radio Interface Protocol stacks, the source data packets in any two of the Radio Interface Protocol stacks correspond to different first network coding modes. In other words, first network coding modes corresponding to source data packets in different Radio Interface Protocol stacks can be distinguished, so this characteristic can be used as a determination criterion to detect the source of a source data packet in the network space. For example, the Radio Interface Protocol stack to which the source data packet belongs can be further determined according to the source of the source data packet, which is not limited herein.

In an embodiment, the first network coding mode includes, but not limited to, at least one of:

Luby Transform (LT) coding;

Rapid Tornado (Raptor) coding;

Raptor Q coding;

Reed-Solomon (RS) coding;

Linear Network Coding (LNC);

Random Linear Network Coding (RLNC); or

Fulcrum Network Coding (FNC).

It can be understood that the first network coding mode may also be set according to specific application scenarios, which is not limited herein. Specific application principle of the above network coding modes will be described respectively in the following embodiments and will not be described in detail here.

In an embodiment, the first network coding parameter includes, but not limited to, at least one of:

coding mode indication information;

a transmission direction of the source data packet;

quantity information of the source data packet;

size information of the source data packet;

quantity information of the first encoded data packet;

quantity information of a redundant data packet;

a code rate;

throughput;

reliability requirement;

an erasure rate;

an encoding matrix;

index information of the first encoded data packet;

layer information of a Radio Interface Protocol stack;

user type information;

channel state information;

an application scenario;

a network frequency range;

UE capability information; or

network bandwidth.

A specific configuration content of the first network coding parameter may be:

a data transmission direction, including an uplink transmission direction and a downlink transmission direction;

a quantity of source data packets, defined as k, which is an integer greater than 0;

a size of the source data packet, defined as T, which is an integer greater than 0;

a quantity of first encoded data packets, defined as n, which is an integer greater than 0 and greater than k;

a quantity of redundant data packets, defined as r, which is an integer greater than 0 and is the difference between n and k;

a code rate, defined as R, which is a real number greater than 0 and less than 1;

a throughput, defined as Tp, which is used to represent an actual amount of data required to pass through a channel per unit time;

a reliability, defined as Pr, which is a real number greater than 0 and less than or equal to 1;

an erasure rate, defined as Pe, which is a real number greater than or equal to 0 and less than or equal to 1; and

a user type, which may be various user types defined in a wireless mobile communication system, where different user types may be determined by a set of parameters including at least one of: an uplink peak data rate, a maximum number of antennas, a downlink peak data rate, or a maximum modulation order.

Based on the first network coding mode and the first network coding parameters, it may be determined that a specific first network coding mode may have a mapping relationship with one or more first network coding parameters. The mapping relationship includes, but not limited to, a mapping formula, a mapping table, a mapping chart, and other expressions indicating a correspondence relationship. The mapping relationship will be described in the following embodiments.

It can be understood that the first network coding parameter may also be set according to specific application scenarios, which is not limited herein. Specific application principle of the above first network coding parameter will be described in the following embodiments and will not be described in detail here.

In an embodiment of the present disclosure, steps prior to S110 are further described, and prior to S110, the method further include at least one of:

acquiring the pre-configured first network coding parameter sent through high-layer signaling; or

acquiring the pre-configured first network coding parameter sent through header information of the source data packet.

In this step, the pre-configured first network coding parameter may be sent through higher-layer signaling, or may be carried by the source data packet, for example, carried and sent by header information of the source data packet, so as to ensure that the pre-configured first network coding parameter can be obtained stably and reliably. The method for configuring the first network coding parameter may also be selected by those having ordinary skills in the art according to specific application scenarios, which is not limited herein.

At S120, the at least one source data packet is encoded according to the first network coding mode to obtain a first encoded data packet.

In this step, because the first network coding mode for the source data packet has been determined in S110, the source data packet may be encoded according to the first network coding mode to obtain a first encoded data packet, such that the obtained first encoded data packet can be sent to the first receiving end in subsequent steps, and the first receiving end can process the first encoded data packet.

Specific examples are given below to illustrate the operating principle and procedures of the foregoing embodiments.

Example One:

For S120, k source data packets $\mathbf{D} = [\mathbf{D_0}; \mathbf{D_1}; \cdots ; \mathbf{D_{k-1}}]$ are input, where an $i^{th}$ source data packet is defined as $\mathbf{D}_i = [d_{i,0}, d_{i,1}, \cdots, d_{i,T-1}]$, $i = 0, 1, \cdots, k-1$, which has a size of T bytes.

The source data packets are encoded to output n first encoded data packets $\mathbf{R} = [\mathbf{R_0}; \mathbf{R_1}; \cdots; \mathbf{R_{n-1}}]$, where a $j$th first encoded data packet is defined as $\mathbf{R_j} = \left[ r_{j,0}, r_{j,1}, \cdots, r_{j,T-1} \right]$, $j = 0, 1, \cdots, n\text{-}1$, which has a size of T bytes, k being an integer greater than 0, and T being an integer greater than 0.

In an embodiment, the source data packet may be encoded according to the first network coding mode by a variety of methods, which may be selected by those having ordinary skills in the art according to specific scenarios. Specific implementations will be described below.

When the first network coding mode includes LT coding, the first network coding parameter includes at least one of:

a first random seed;

a second random seed; or

a first degree distribution indication.

In an implementation, when the first network coding parameter includes the first random seed, the first random seed is determined by at least one of index information of the first encoded data packet, quantity information of the source data packet, or quantity information of the first encoded data packet.

In another implementation, when the first network coding parameter includes the second random seed, the second random seed is determined by at least one of index information of the first encoded data packet, quantity information of the source data packet, or quantity information of the first encoded data packet.

In another implementation, when the first network coding parameter includes the first random seed and the second random seed, the first random seed and the second random seed are determined by at least one of index information of the first encoded data packet, quantity information of the source data packet, or quantity information of the first encoded data packet.

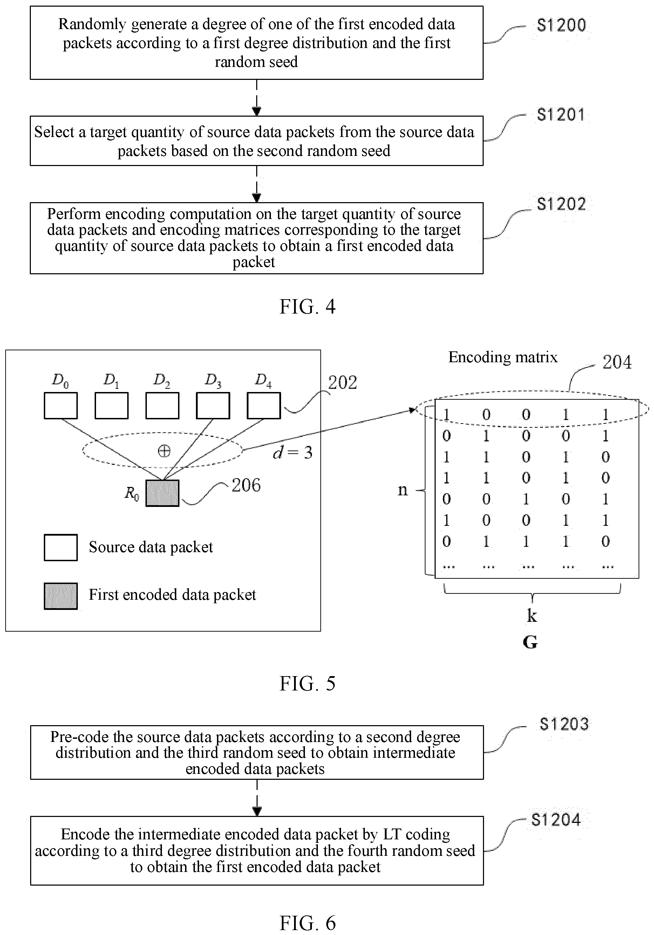

As shown in FIG. 4, in an embodiment of the present disclosure, when the first network coding parameter includes the first random seed, the second random seed, and the first degree distribution indication, S120 is further described, and S120 may include, but not limited to, the following steps S1200 to S1202.

At S1200, a degree of one of the first encoded data packets is randomly generated according to a first degree distribution and the first random seed, where the first degree distribution is determined according to the first degree distribution indication.

At S1201, a target quantity of source data packets is selected from the source data packets based on the second random seed, where the target quantity is the generated degree of the first encoded data packet.

At S1202, encoding computation is performed on the target quantity of source data packets and encoding matrices corresponding to the target quantity of source data packets to obtain a first encoded data packet.

In this step, with the use of the first random seed, the second random seed, and the first degree distribution indication in combination for processing, encoding computation can be performed on the target quantity of source data packets and encoding matrices corresponding to the target quantity of source data packets to obtain the first encoded data packet, such that the first encoded data packet can be further sent out in subsequent steps.

It can be understood that the first random seed, the second random seed, and the first degree distribution indication are well known to those having ordinary skills in the art and therefore will not be described in detail herein. Specific application scenarios of the first random seed, the second random seed, and the first degree distribution indication will be described in the following examples.

Example Two:

As shown in FIG. 5, based on LT coding, the following steps are executed.

At step one, raw data is evenly divided into k source data packets, where an $i$th source data packet is defined as $\mathbf{D_i}$, $i = 0, 1, ..., k\text{-}1$, and k is a positive integer.

At step two, a degree d of a $j$th encoded data packet $\mathbf{R_j}$ is randomly generated according to a degree distribution and a first random seed, where $j$ is a non-negative integer, d is a positive integer, and the degree distribution is determined according to the first degree distribution indication.

At step three, d integers $n1, n2, \cdots nd$ are randomly and evenly selected from 0 to k-1 according to a second random seed.

At step four, a $j$th encoded data packet $\mathbf{R_j}$ is obtained using an exclusive OR calculation formula according to d source data packets with indexes $n1, n2, \cdots nd$:

$$\mathbf{R}_j = \mathbf{D}_{n1} \oplus \mathbf{D}_{n2} \oplus \cdots \oplus \mathbf{D}_{nd}$$

The above steps two, three, and four are repeated to generate encoded data packets. Matrix multiplication may be used to express the encoding process of the steps two, three, and four as follows:

$$\mathbf{R} = \mathbf{G} \cdot \mathbf{D};$$

where G represents the encoding matrix, with a size of n rows and k columns, and n is the number of times an LT encoded data packet is repeatedly generated in the steps two, three, and four. In a $j^{th}$ row vector of the encoding matrix, elements corresponding to indexes $n1$, $n2$, $\cdots nd$ generated in the step three are equal to 1, and the remaining elements are equal to 0. As can be seen, in the LT coding example shown in FIG. 5, k is an integer greater than 0. In an example, k is equal to 5, i.e., the raw data is divided into five source data packets 202, where one of the encoded data packets 206 corresponds to a degree of 3, and this encoded data packet corresponds to 204 in the encoding matrix G.

In an embodiment, because this embodiment and the following related embodiments are all described using the first encoded data packet, "encoded data packet" shall be construed as "first encoded data packet" shown in S120, i.e., the two have the same meanings, unless otherwise stated.

When the first network coding mode includes Raptor coding, the first network coding parameter includes at least one of:

a third random seed;

a fourth random seed;

a second degree distribution indication; or

a third degree distribution indication.

In an implementation, when the first network coding parameter includes the third random seed, the third random seed is determined by at least one of index information of the first encoded data packet, quantity information of the source data packet, or quantity information of the first encoded data packet.

In another implementation, when the first network coding parameter includes the fourth random seed, the fourth random seed is determined by at least one of index information of the first encoded data packet, quantity information of the source data packet, or quantity information of the first encoded data packet.

In another implementation, when the first network coding parameter includes the third random seed and the fourth random seed, the third random seed and the fourth random seed are determined by at least one of index information of the first encoded data packet, quantity information of the source data packet, or quantity information of the first encoded data packet.

As shown in FIG. 6, in an embodiment of the present disclosure, when the first network coding parameter includes the third random seed, the fourth random seed, the second degree distribution indication, and the third degree distribution indication, S120 is further described, and S120 may include, but not limited to, the following steps S1203 to S1204.

At S1203, the source data packets are pre-coded according to a second degree distribution and the third random seed to obtain intermediate encoded data packets, where the second degree distribution is determined according to the second degree distribution indication.

At S1204, the intermediate encoded data packet is encoded by LT coding according to a third degree distribution and the fourth random seed to obtain the first encoded data packet, where the third degree distribution is determined according to the third degree distribution indication.

In this step, with the use of the third random seed, the fourth random seed, the second degree distribution indication, and the third degree distribution indication in combination for processing, the intermediate encoded data packet can be encoded by LT coding to obtain the first encoded data packet, such that the first encoded data packet can be further sent out in subsequent steps.

Example Three:

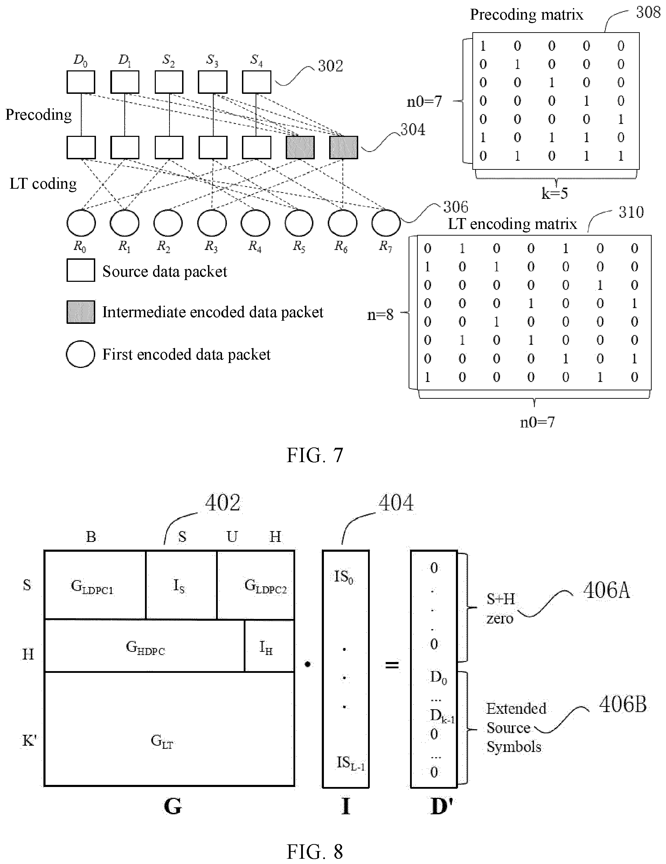

As shown in FIG. 7, compared with LT coding, Raptor coding outperforms LT coding but has higher encoding and decoding complexity in the case of receiving the same number of redundant encoded data packets.

The Raptor coding process includes precoding and LT coding. k source data packets 302 are pre-coded according to a degree distribution and a third random seed. The precoding includes, but not limited to, Low Density Parity Check Code (LDPC) coding. k is an integer greater than 0. In an example, k=5. A precoding matrix 308 has a size of n0 rows and k columns. Through the precoding, n0 intermediate encoded data packets 304 are obtained, where n0 is an integer greater than k. In an example, n0=7. Then, the intermediate encoded data packets are encoded by LT coding according to a fourth random seed and a degree distribution. The degree distribution is determined according to a third degree distribution indication. n is an integer greater than n0. In an example, n=8. An LT encoding matrix 310 has a size of n rows and n0 columns. The pre-encoding matrix and the encoding matrix are composed of elements {0, 1}.

When the first network coding mode includes Raptor Q coding, the first network coding parameter includes at least one of:

a fifth random seed; or

a fourth degree distribution indication.

In an implementation, when the first network coding parameter includes the fifth random seed, the fifth random seed is determined by at least one of index information of the first encoded data packet, quantity information of the source data packet, or quantity information of the first encoded data packet.

In an embodiment of the present disclosure, when the first network coding parameter includes the fifth random seed and the fourth degree distribution indication, S120 is further described, and S120 may include, but not limited to, a following step S1205.

At S1205, when intermediate symbols corresponding to the source data packets are determined, the intermediate symbols are encoded by LT coding according to a fourth degree distribution and the fifth random seed to obtain the first encoded data packet, where the fourth degree distribution is determined according to the fourth degree distribution indication.

In this step, the intermediate symbols corresponding to the source data packets are determined, and the intermediate symbols are encoded by LT coding based on the combination of the fifth random seed and the fourth degree distribution to obtain the first encoded data packet, such that the first encoded data packet can be sent out in subsequent steps.

Example Four:

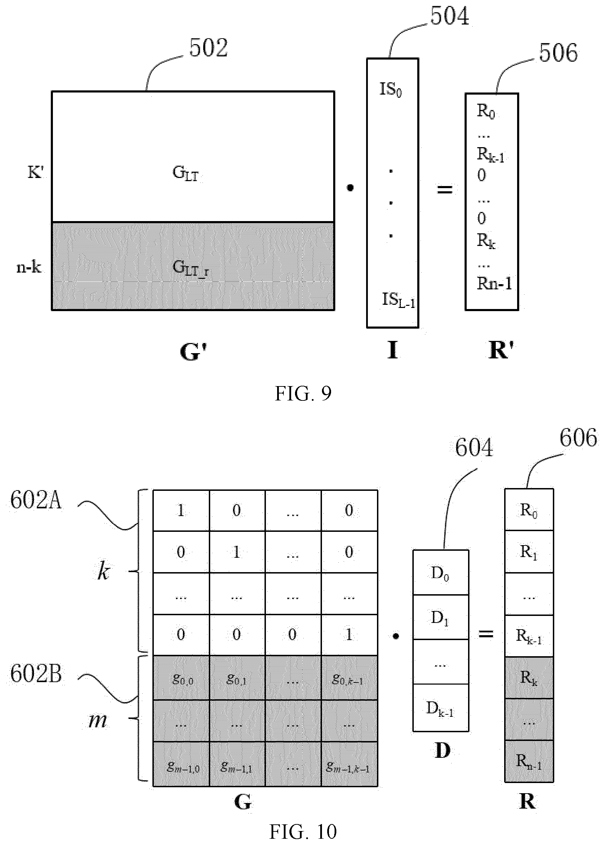

As shown in FIG. 8 and FIG. 9, Raptor Q coding is a further development of Raptor coding. It outperforms Raptor coding but has higher encoding and decoding complexity.

As shown in FIG. 8, 402 represents a construction matrix G of Raptor Q, which is composed of multiple submatrices. $G_{LDPC1}$ and $G_{LDPC2}$ each represent a low-density parity-check matrix composed of elements {0, 1} in a finite field. $G_{HDPC}$ represents a high-density parity-check matrix in a finite field. $I_S$ and $I_H$ respectively represent identity matrices with orders S and H. $G_{LT}$ represents an LT encoding matrix. S, H, B, U, and K' respectively represent the sizes of corresponding submatrices, and are all positive integers. In an embodiment, S, H, B, U, and K' are determined by the value of k. 404 represents an intermediate symbol I with a size of L, where L is determined by the value of k. D' is obtained by two zero padding, where 406A contains S+H elements "0" (the first padding), 406B contains k source data packets $D = [D_0; D_1; \cdots; D_{k-1}]$, and the last K'-k elements are "0" (the second padding). If the construction matrix G is invertible, the intermediate symbol I corresponding to D' can be obtained. In this case, the encoded data packet $R = [R_0; R_1; \cdots; R_{n-1}]$; can be obtained by LT encoding the intermediate symbol I.

As shown in FIG. 9, an example of Raptor Q coding of the intermediate symbol I is provided, where a matrix operation is performed on an encoding matrix 502 and an intermediate symbol 504 in a finite field to obtain data 506. The data 506 includes K'-k elements "0" in the second padding and n encoded data packets $R = [R_0; R_1; \cdots; R_{n-1}]$, where n is an integer greater than k. $G_{LT\_r}$ represents an LT encoding matrix for generating redundant encoding symbols. $G_{LT\_r}$ is obtained according to a degree distribution and a fifth random seed. The degree distribution is determined according to a fourth degree distribution indication.

In an embodiment, Raptor Q coding supports a maximum of 56403 source data packets and a maximum encoded data packet size of $2^{24}$ bytes, while Raptor coding supports a maximum of 8192 source data packets and a maximum encoded data packet size of $2^{16}$ bytes.

In an embodiment of the present disclosure, when the first network coding mode includes RS coding, S120 is further described, and S120 may include, but not limited to, a following step S1206.

At S1206, when the encoding matrix is determined, matrix calculation is performed on the encoding matrix and the source data packets in a finite field to obtain the first encoded data packet.

In this step, the first encoded data packet can be obtained by performing matrix calculation on the encoding matrix and the source data packets in a finite field, such that the first encoded data packet can be sent out in subsequent steps.

Example Five:

RS coding is a finite field-based coding algorithm. In the case of the same finite field and receiving the same quantity of redundant encoded data packets, RS coding has higher performance and decoding complexity than Raptor Q coding. FIG. 10 shows an implementation process of RS coding. As shown in FIG. 10,

first, an encoding matrix G is determined. The encoding matrix G includes an upper part 602A which is an identity matrix and a lower part 602B which is an m*k matrix, where m=n-k. A matrix operation is performed on the encoding matrix and the input source data packets $D = [D_0;D_1;\cdots;D_{k-1}]$ 604 in a finite field to obtain encoded data packets $R = [R_0;R_1;\cdots;R_{n-1}]$ 606.

In an embodiment, the lower part 602B may be a Vandermonde Matrix (VM) as shown below, where $a_i^j$ represents a $j^{th}$ power of an element $a_i$ in the finite field, and $j$ is a non-negative integer.

$$VM = \begin{bmatrix} a_0^0 & a_1^0 & a_2^0 & \dots & a_{k-1}^0 \\ a_0^1 & a_1^1 & a_2^1 & \dots & a_{k-1}^1 \\ a_0^2 & a_1^2 & a_2^2 & \dots & a_{k-1}^2 \\ \vdots & \vdots & \vdots & \ddots & \vdots \\ a_0^{m-1} & a_1^{m-1} & a_2^{m-1} & \dots & a_{k-1}^{m-1} \end{bmatrix}$$

In an embodiment, the lower part 602B may be a Cauchy Matrix (CM) as shown below, where $a_i$ and $b_i$ represent elements in the finite field.

$$CM = \begin{bmatrix} \dfrac{1}{a_0+b_0} & \dfrac{1}{a_0+b_1} & \dfrac{1}{a_0+b_2} & \dots & \dfrac{1}{a_0+b_{k-1}} \\ \dfrac{1}{a_1+b_0} & \dfrac{1}{a_1+b_1} & \dfrac{1}{a_1+b_2} & \dots & \dfrac{1}{a_1+b_{k-1}} \\ \dfrac{1}{a_2+b_0} & \dfrac{1}{a_2+b_1} & \dfrac{1}{a_2+b_2} & \dots & \dfrac{1}{a_2+b_{k-1}} \\ \vdots & \vdots & \vdots & \ddots & \vdots \\ \dfrac{1}{a_{m-1}+b_0} & \dfrac{1}{a_{m-1}+b_1} & \dfrac{1}{a_{m-1}+b_2} & \dots & \dfrac{1}{a_{m-1}+b_{k-1}} \end{bmatrix}$$

When the first network coding mode includes RLNC, the first network coding parameter includes a sixth random seed.

In an implementation, when the first network coding parameter includes the sixth random seed, the sixth random seed is determined by at least one of index information of the first encoded data packet, quantity information of the source data packet, or quantity information of the first encoded data packet.

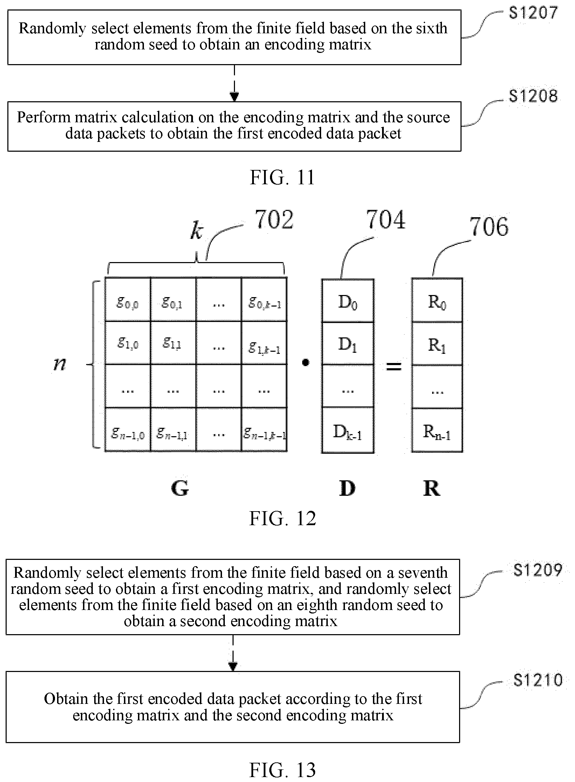

As shown in FIG. 11, in an embodiment of the present disclosure, when the first network coding parameter includes the sixth random seed, S120 is further described, and S120 may include, but not limited to, the following steps S1207 to S1208.

At S1207, elements are randomly selected from the finite field based on the sixth random seed to obtain an encoding matrix.

At S1208, matrix calculation is performed on the encoding matrix and the source data packets to obtain the first encoded data packet.

In this step, the first encoded data packet can be obtained by selecting the encoding matrix according to the sixth random seed and performing matrix calculation on the encoding matrix and the source data packets in a finite field, such that the first encoded data packet can be sent out in subsequent steps.

Example Six:

RLNC is a coding method that can be defined over a finite field. An encoding matrix is randomly selected in the finite field. According to the encoding matrix, input source data packets are linearly combined in the coding process. In an example, the finite field of RLNC is GF (2). In the case of receiving the same quantity of redundant encoded data packets, RLNC has lower performance than Raptor Q coding and RS coding, but has higher flexibility.

FIG. 12 shows an example based on RLNC, where dimensions of an encoding matrix G 702 are n rows and k columns. The encoding matrix G is obtained by randomly selecting elements from the finite field according to a sixth random seed. k encoded data packets $\mathbf{D} = [\mathbf{D_0};\mathbf{D_1};\cdots;\mathbf{D_{k-1}}]$ 704 are input, and encoded to obtain encoded data packets $\mathbf{R} = [\mathbf{R_0};\mathbf{R_1};\cdots;\mathbf{R_{n-1}}]$ 706. k is an integer greater than 0, and n is an integer greater than k.

In an embodiment, an $i^{\text{th}}[g_{i-1,0},g_{i-1,1},\cdots,g_{i-1,k-1}]$ row of the encoding matrix G in FIG. 10 is determined according to the sixth random seed $\text{Seed}_i$, where i is an integer greater than 0 and less than or equal to n, and the sixth random seed $\text{Seed}_i$ is an integer greater than 0 and less than $2^{32}$. Any two random seeds are different. Elements are randomly selected from the finite field according to the sixth random seed $\text{Seed}_i$

In an embodiment, the encoding matrix G in FIG. 12 is generated according to one sixth random seed Seed1, which is an integer greater than 0 and less than $2^{32}$. Elements are randomly selected from the finite field according to the random seed Seed1 to obtain the encoding matrix G.

When the first network coding mode includes FNC, the first network coding parameter includes at least one of:

a seventh random seed; or

an eighth random seed.

In an implementation, when the first network coding parameter includes the seventh random seed, the seventh random seed is determined by at least one of index information of the first encoded data packet, quantity information of the source data packet, or quantity information of the first encoded data packet.

In another implementation, when the first network coding parameter includes the eighth random seed, the eighth random seed is determined by at least one of index information of the first encoded data packet, quantity information of the source data packet, or quantity information of the first encoded data packet.

In another implementation, when the first network coding parameter includes the seventh random seed and the eighth random seed, the seventh random seed and the eighth random seed are determined by at least one of index information of the first encoded data packet, quantity information of the source data packet, or quantity information of the first encoded data packet.

As shown in FIG. 13, in an embodiment of the present disclosure, when the first network coding parameter includes the seventh random seed and the eighth random seed, S120 is further described, and S120 may include, but not limited to, the following steps S1209 to S1210.

At S1209, elements are randomly selected from the finite field based on a seventh random seed to obtain a first encoding matrix, and elements are randomly selected from the finite field based on an eighth random seed to obtain a second encoding matrix.

At S1210, the first encoded data packet is obtained according to the first encoding matrix and the second encoding matrix.

In this step, the corresponding encoding matrices are respectively selected according to the seventh random seed and the eighth random seed, and the first encoded data packet can be obtained according to the corresponding encoding matrices, such that the first encoded data packet can be sent out in subsequent steps.

Example Seven:

FNC is an extension of RLNC, with its outer encoding being RLNC in a finite field and its inner encoding being RLNC in a binary field.

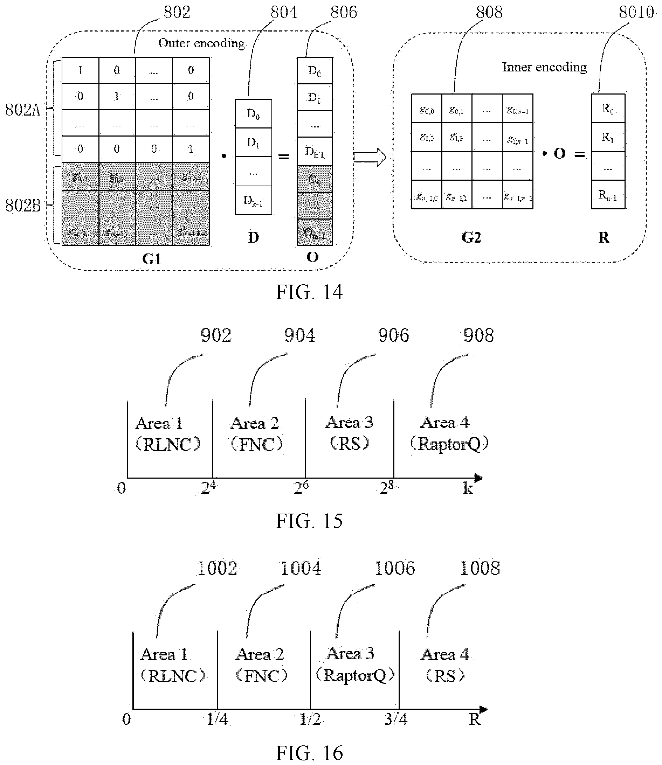

FIG. 14 shows an example of FNC, where systematic coding is used as outer encoding and non-systematic coding is used as inner encoding. Dimensions of an outer encoding coefficient matrix G1 802 are k+m rows and k columns. G1 includes an upper part 802A which is an identity matrix, and a lower part 802B. Any element $g'_{i,j}$ of the lower part 802B is randomly selected from a finite field according to a seventh random seed. k encoded data packets $\mathbf{D} = [\mathbf{D_0};\mathbf{D_1};\cdots;\mathbf{D_{k-1}}]$ 804 are input, and encoded to obtain outer encoded data packets $\mathbf{O}$ 806. Elements in an inner encoding coefficient matrix G2 808 are randomly selected from finite field elements {0, 1} according to an eighth random seed. After FNC, encoded data packets $\mathbf{R} = [\mathbf{R_0};\mathbf{R_1};\cdots;\mathbf{R_{n-1}}]$ 8010 are obtained, where m=n-k. Compared with binary RLNC, FNC has increased encoding and decoding complexity, but has a higher decoding success rate.

In an embodiment, a $j^{\text{th}}$ row $\lfloor g'_{j-1,0},g'_{j-1,1},\cdots,g'_{j-1,k-1}\rfloor$ of the lower part 802A of the outer encoding matrix G1 in FIG. 14 is determined according to a seventh random seed Seed2j, where j is an integer greater than 0 and less than or equal to m, m=n-k, and the random seed Seed2j is an integer greater than 0 and less than $2^{32}$. Any two random seeds are different. Elements are randomly selected from the finite field according to the random seed Seed2j. A $q^{\text{th}}$ $\lfloor g_{q-1,0},g_{q-1,1},\cdots,g_{q-1,n-1}\rfloor$ row of the inner encoding matrix G2 in FIG. 14 is determined according to an eighth random seed Seed3q, where q is an integer greater than 0 and less than or equal to n, and the eighth random seed Seed3q is an integer greater than 0 and less than $2^{32}$. Any two random seeds are different. Elements are randomly selected from finite field elements {0, 1} according to the eighth random seed Seed3q.

In an embodiment, the lower part 802A of the outer encoding matrix G1 in FIG. 14 is determined according to one seventh random seed Seed4, which is an integer greater than 0 and less than $2^{32}$. Elements are randomly selected from the finite field according to the random seed Seed4 to obtain the encoding matrix G1. The inner encoding matrix G2 in FIG. 8 is determined according to one eighth random seed Seed5, which is an integer greater than 0 and less than $2^{32}$. Elements are randomly selected from finite field elements {0, 1} according to the random seed Seed5 to obtain the encoding matrix G2.

In an embodiment, an order of the finite field elements described in the above embodiments may be one of: 256, 65536, 16, 32, 64, 1024, or 4096.

When the first network coding parameter includes the coding mode indication information, the coding mode indication information includes at least one of:

first coding mode indication information for indicating whether to use a network coding mode;

second coding mode indication information for indicating to use at least one network coding mode; or

third coding mode indication information for indicating whether to use a network coding mode and indicating to use at least one network coding mode.

In other words, the coding mode indication information may be configured as a multi-dimensional indication to achieve a satisfactory and reliable coding mode indication effect.

Example Eight:

In this example, the coding mode indication information includes at least one of:

1 bit indicating whether to use network coding; or

p bits indicating a network coding mode to be used.

p is an integer greater than 0, and the p bits indicate a maximum of $2^p$ coding modes. For example, as shown in Table 1 below, when p is equal to 2, four coding modes can be selected, where "00" represents RLNC, "01" represents RS coding, "10" represents Raptor Q coding, and "11" represents FNC. It can be understood that the network coding modes are not limited to RLNC, RS coding, Raptor Q coding, and FNC, and other network coding modes may also be used.

Table 1 shows an example table of network coding mode configuration when the coding mode indication information indicates to use a network coding mode and p=2.

| S1 | S0 | Method |
|---|---|---|
| 0 | 0 | RLNC |
| 0 | 1 | RS |
| 1 | 0 | Raptor Q |
| 1 | 1 | FNC |

In an embodiment, p bits are used to indicate whether to use a network coding mode and indicate which network coding mode is to be used. p is an integer greater than 0, and the p bits indicate a maximum of $2^p - 1$ network coding modes. One of combinations of the p bits indicates that network coding is not used. For example, as shown in Table 2 below, when p is equal to 2, three coding modes can be selected, where "00" represents that network coding is not used, "01" represents RS coding, "10" represents Raptor Q coding, and "11" represents FNC. It can be understood that in this example, the network coding modes are not limited to RS coding, Raptor Q coding, and FNC, and other network coding modes may also be used.

Table 2 shows another example table of network coding mode configuration when the coding mode indication information indicates to use a network coding mode and p=2.

| S1 | S0 | Method |
|---|---|---|
| 0 | 0 | NULL |
| 0 | 1 | RS |
| 1 | 0 | Raptor Q |
| 1 | 1 | FNC |

In an embodiment of the present disclosure, when the first network coding parameter includes the transmission direction of the source data packet, S110 is further described, and S110 may include, but not limited to, at least one of:

determining RS coding as the first network coding mode when the transmission direction of the source data packet is an uplink transmission direction; or

determining Raptor Q coding as the first network coding mode when the transmission direction of the source data packet is a downlink transmission direction.

In this step, the transmission direction of the source data packet is determined, and the corresponding matching network coding mode can be selected according to the determined transmission direction of the source data packet.

Example Nine:

Uplink data transmission at least includes: a UE sending data to a base station or a UE sending data to a relay. Downlink data transmission at least includes: the base station sending data to the UE or the relay sending data to the UE.
In an embodiment, the network coding modes include Raptor Q coding and RS coding, and a network coding mode is determined according to the data transmission direction. For example, if the data transmission direction is uplink data transmission, the network coding mode is RS coding; if the data transmission direction is downlink data transmission, the network coding mode is Raptor Q coding.
In an embodiment, because the data volume of downlink data transmission is generally larger than that of uplink data transmission, and the maximum source data packet size supported by Raptor Q coding is generally larger than that of RS coding, Raptor Q coding is more suitable for downlink data transmission, and RS coding should be used for uplink data transmission.
In an embodiment, the network coding modes in this example are not limited to Raptor Q coding and RS coding, but may include, but not limited to, at least two of: LT coding, Raptor coding, Raptor Q coding, RS coding, LNC, RLNC, and FNC.
In an embodiment of the present disclosure, when the first network coding parameter includes the application scenario, S110 is further described, and S110 may include, but not limited to, at least one of:

determining RS coding as the first network coding mode when the application scenario is URLLC;

determining Raptor Q coding as the first network coding mode when the application scenario is eMBB; or

determining FNC as the first network coding mode when the application scenario is Massive Machine Type Communications (mMTC).

In this step, the specific application scenario is determined, and the corresponding matching network coding mode can be selected according to the determined specific application scenario.

Example Ten:

The application scenarios include URLLC, eMBB, and mMTC. In an example, at least two of the application scenarios correspond to different network coding modes.
The network coding modes include FNC, Raptor Q coding, and RS coding, and a network coding mode is determined according to the application scenario.
In an embodiment, if the application scenario is URLLC, the network coding mode is RS coding, which has higher reliability.

In an embodiment, if the application scenario is eMBB, the network coding mode is Raptor Q coding, which supports more encoded data packets and can meet high data rate requirements.

In an embodiment, if the application scenario is mMTC, the network coding mode is FNC, which has a flexible coding mode and can satisfy the encoding of massive terminal device data.

In an embodiment, the network coding modes in this example are not limited to RS coding, Raptor Q coding, and FNC, but may include, but not limited to, at least three of: LT coding, Raptor coding, Raptor Q coding, RS coding, LNC, RLNC, and FNC.

In an embodiment of the present disclosure, when the first network coding parameter includes the network frequency range, S110 is further described, and S110 may include, but not limited to, at least one of:

when the network frequency range includes a first network frequency range and a second network frequency range, determining RS coding as the first network coding mode within the first network frequency range and determining Raptor Q coding as the first network coding mode within the second network frequency range, where frequencies in the first network frequency range are lower than frequencies in the second network frequency range; or

when the network frequency range includes a first network frequency range and a second network frequency range, determining RS coding as the first network coding mode within the first network frequency range and determining FNC as the first network coding mode within the second network frequency range, where frequencies in the first network frequency range are lower than frequencies in the second network frequency range.

In this step, the specific network frequency range is determined, and the corresponding matching network coding mode can be selected according to the determined specific network frequency range.

In an embodiment, specific values of the first network frequency range and the second network frequency range are not limited. That is to say, the values of the first network frequency range and the second network frequency range may be set by those having ordinary skills in the art according to actual application scenarios, which is not limited herein.

Example Eleven:

The network frequency ranges include FR1 and FR2. A network coding mode corresponding to FR1 is different from that corresponding to FR2.

In an embodiment, the network coding mode corresponding to FR1 is RS coding, and the network coding mode corresponding to FR2 is Raptor Q coding.

In another embodiment, the network coding mode corresponding to FR1 is RS coding, and the network coding mode corresponding to FR2 is FNC.

In an example, a frequency range below 6 GHz is referred to as FR1, and a frequency range in the millimeter wave band is referred to as FR2. For example, a frequency range from 450 MHz to 6000 MHz is referred to as FR1, and a frequency range from 24250 MHz to 52600 MHz is referred to as FR2.

In an embodiment, the network coding modes in this example are not limited to RS coding, Raptor Q coding, and FNC, but may include, but not limited to, at least two of: LT coding, Raptor coding, Raptor Q coding, RS coding, LNC, RLNC, and FNC.

In an embodiment of the present disclosure, when the first network coding parameter includes the UE capability information, S110 is further described, and S110 may include, but not limited to, at least one of:

determining Raptor Q coding as the first network coding mode when the UE capability information includes a maximum number of antennas supported and the maximum number of antennas supported is greater than a first threshold, where the first threshold is one of 4, 6, 8, 12, or 16;

determining RS coding as the first network coding mode when the UE capability information includes a maximum number of antennas supported and the maximum number of antennas supported is not greater than a first threshold, where the first threshold is one of 4, 6, 8, 12, or 16;

determining Raptor Q coding as the first network coding mode when the UE capability information includes a maximum modulation order supported and the maximum modulation order supported is greater than a second threshold, where the second threshold is one of 4, 6, 8, or 10;

determining RS coding as the first network coding mode when the UE capability information includes a maximum modulation order supported and the maximum modulation order supported is not greater than a second threshold, where the second threshold is one of 4, 6, 8, or 10;

determining Raptor Q coding as the first network coding mode when the UE capability information includes a maximum data rate supported and the maximum data rate supported is greater than a third threshold, where the third threshold is one of 500 Mbps, 1 Gbps, or 10 Gbps; or

determining RS coding as the first network coding mode when the UE capability information includes a maximum data rate supported and the maximum data rate supported is not greater than a third threshold, where the third threshold is one of 500 Mbps, 1 Gbps, or 10 Gbps.

In this step, the specific UE capability information is determined, and the corresponding matching network coding mode can be selected according to a threshold range within which the determined specific UE capability information falls.

In an embodiment, specific values of the first threshold, the second threshold, and the third threshold are not limited. That is to say, the values of the first threshold, the second threshold, and the third threshold may be set by those having ordinary skills in the art according to actual application scenarios, which is not limited herein.

Example Twelve:

In an example, if the maximum number of antennas supported by the UE is greater than w1, Raptor Q coding is used; otherwise, RS coding is used. w1 is equal to one of: 4, 6, 8, 12, or 16.

In an example, if the maximum modulation order supported by the UE is greater than w2, Raptor Q coding is used; otherwise, RS coding is used. w2 is equal to one of: 4, 6, 8, or 10.

In an example, if the maximum data rate supported by the UE is greater than w3, Raptor Q coding is used; otherwise, RS coding is used. w3 is equal to one of: 500 Mbps, 1 Gbps, or 10 Gbps.

In an embodiment, the network coding modes in this example are not limited to RS coding and Raptor Q coding, but may include, but not limited to, at least two of: LT coding, Raptor coding, Raptor Q coding, RS coding, LNC, RLNC, and FNC.

In an embodiment of the present disclosure, when the first network coding parameter includes the network bandwidth, S110 is further described, and S110 may include, but not limited to, at least one of:

determining LT coding as the first network coding mode when the network bandwidth is configured to be a first network bandwidth;

determining Raptor Q coding as the first network coding mode when the network bandwidth is configured to be a second network bandwidth;

determining RS coding as the first network coding mode when the network bandwidth is configured to be a third network bandwidth; or

determining FNC as the first network coding mode when the network bandwidth is configured to be a fourth network bandwidth.

In this step, the specific network bandwidth is determined, and the corresponding matching network coding mode can be selected according to the determined specific network bandwidth.

In an embodiment, specific values of the first network bandwidth, the second network bandwidth, the third network bandwidth, and the fourth network bandwidth are not limited. That is to say, the values of the first network bandwidth, the second network bandwidth, the third network bandwidth, and the fourth network bandwidth may be set by those having ordinary skills in the art according to actual application scenarios, which is not limited herein. For example, a relationship between the values of the bandwidths may be set.

Example Thirteen:

On each unit carrier in the uplink or downlink direction, one UE can configure a maximum of four BWPs (denoted as BWP 0, BWP 1, BWP 2, and BWP 3), only one of which is active at a certain moment. The network coding modes include LT coding, Raptor Q coding, RS coding, and FNC, and a network coding mode is determined according to the BWP.

In an example, when the BWP is configured to be BWP 0, the network coding mode is LT coding; when the BWP is configured to be BWP 1, the network coding mode is Raptor Q coding; when the BWP is configured to be BWP 2, the network coding mode is RS coding; and when the BWP is configured to be BWP 3, the network coding mode is FNC.

In an embodiment, the network coding modes in this example are not limited to LT coding, Raptor Q coding, RS coding, and FNC, but may include, but not limited to, at least four of: LT coding, Raptor coding, Raptor Q coding, RS coding, LNC, RLNC, and FNC.

In an embodiment of the present disclosure, when the first network coding parameter includes the quantity information of the source data packet, S110 is further described, and S110 may include, but not limited to, a following step S1101.

At S1101, when a first mapping relationship between at least two preset network coding modes and the quantity information of the source data packet is determined, the first network coding mode is selected from the preset network coding modes according to the quantity information of the source data packet and the first mapping relationship.

In an embodiment, the first mapping relationship is used to characterize a quantity of the source data packets supported by each of the preset network coding modes.

In this step, the first mapping relationship between the preset network coding modes and the quantity information of the source data packet is determined, and the first network coding mode can be selected from the preset network coding modes according to the quantity information of the source data packet and the first mapping relationship. In this way, the obtained first network coding mode can be well associated with the quantity information of the source data packet, providing high accuracy.

Example Fourteen:

There are multiple value ranges for the quantity of source data packets. There is no intersection between any two of the value ranges. The network coding modes used by any two of the value ranges are different. The multiple value ranges include at least two value ranges.

In an embodiment, the network coding mode is determined according to the value of the quantity k of source data packets, i.e., a mapping relationship $g : k \rightarrow Method$ exists between the network coding mode and k. When the network coding mode is RLNC, the quantity of source data packets supported by the network coding mode is defined as k1. When the network coding mode is FNC, the quantity of source data packets supported by the network coding mode is defined as k2. When the network coding mode is RS coding, the quantity of source data packets supported by the network coding mode is defined as k3. When the network coding mode is Raptor Q coding, the quantity of source data packets supported by the network coding mode is defined as k4.

In an example, k1 is less than k2. In an example, k2 is less than k3. In an example, k3 is less than k4. In an example, k1 is less than k2, and k2 is less than k3. In an example, k1 is less than k2, k2 is less than k3, and k3 is less than k4. In an example, a maximum value of k1 is equal to an integer from 12 to 20, a maximum value of k2 is equal to an integer from 56 to 72, and a maximum value of k3 is equal to an integer from 240 to 270.

As shown in FIG. 15, when the network coding modes include RLNC, FNC, RS coding, and Raptor Q coding, the maximum value of k1 is equal to 16, the maximum value of k2 is equal to 64, and the maximum value of k3 is equal to 256. A value range 902 of k corresponding to RLNC is greater than 0 and less than or equal to 16. In this range, RLNC has higher coding and decoding throughput, and the reliability requirement can be met by adding redundant encoded data packets. A value range 904 of k corresponding to FNC is greater than 16 and less than or equal to 64. In this range, FNC has higher reliability than RLNC and has lower coding and decoding complexity than RS coding. A value range 906 of k corresponding to RS coding is greater than 64 and less than or equal to 256. In this range, RS coding has higher reliability. A value range 908 of k corresponding to Raptor Q coding is greater than 256. In this range, Raptor Q coding supports more source data packets.

It can be understood that the multiple value ranges are not limited to the values described above, and may also be other values.

In an embodiment, the network coding modes in this example are not limited to RLNC, FNC, RS coding, and Raptor Q coding, but may include, but not limited to, at least two of: LT coding, Raptor coding, Raptor Q coding, RS coding, LNC, RLNC, and FNC.

In an embodiment of the present disclosure, when the first network coding parameter includes the size information of the source data packet, S110 is further described, and S110 may include, but not limited to, a following step S1102.

At S1102, when a second mapping relationship between at least two preset network coding modes and the size information of the source data packet is determined, the first network coding mode is selected from the preset network coding modes according to the size information of the source data packet and the second mapping relationship.

In an embodiment, the second mapping relationship is used to characterize a size of the source data packet supported by each of the preset network coding modes.

In this step, the second mapping relationship between the preset network coding modes and the size information of the source data packet is determined, and the first network coding mode can be selected from the preset network coding modes according to the size information of the source data packet and the second mapping relationship. In this way, the obtained first network coding mode can be well associated with the size information of the source data packet, providing high accuracy.

Example Fifteen:

There are multiple value ranges for the source data packet size. There is no intersection between any two of the value ranges. The network coding modes used by any two of the value ranges are different. The multiple value ranges include at least two value ranges. In an embodiment, the network coding mode is determined according to the value of the source data packet size T, i.e., a mapping relationship $g: T \rightarrow Method$ exists between the network coding mode and T. When the network coding mode is FNC, the source data packet size supported by the network coding mode is defined as k5. When the network coding mode is RS coding, the source data packet size supported by the network coding mode is defined as k6. When the network coding mode is Raptor Q coding, the source data packet size supported by the network coding mode is defined as k7.

In an example, k5 is less than k6. In an example, k6 is less than k7. In an example, k5 is less than k6, and k6 is less than k7. In an example, a maximum value of k5 is equal to an integer from 12 to 20, and a maximum value of k6 is equal to an integer from 240 to 270.

In an example, the network coding modes include FNC, RS coding, and Raptor Q coding, the maximum value of k5 is equal to 16, and the maximum value of k6 is equal to 256. A value range of T corresponding to FNC is greater than 0 and less than or equal to 16. In this range, FNC has lower coding and decoding complexity. A value range of T corresponding to RS coding is greater than 16 and less than or equal to 256. In this range, RS coding has higher reliability. A value range of T corresponding to Raptor Q coding is greater than 256. In this range, Raptor Q coding supports a larger encoded data packet size. The multiple value ranges are not limited to the values described above, and may also be equal to other values.

In an embodiment, the network coding modes in this example are not limited to FNC, RS coding, and Raptor Q coding, but may include, but not limited to, at least two of: LT coding, Raptor coding, Raptor Q coding, RS coding, LNC, RLNC, and FNC.

In an embodiment of the present disclosure, when the first network coding parameter includes the quantity information of the first encoded data packet, S110 is further described, and S110 may include, but not limited to, a following step S1103.

At S1103, when a third mapping relationship between at least two preset network coding modes and the quantity information of the first encoded data packet is determined, the first network coding mode is selected from the preset network coding modes according to the quantity information of the first encoded data packet and the third mapping relationship.

In an embodiment, the third mapping relationship is used to characterize a quantity of first encoded data packets supported by each of the preset network coding modes.

In this step, the third mapping relationship between the preset network coding modes and the quantity information of the first encoded data packet is determined, and the first network coding mode can be selected from the preset network coding modes according to the quantity information of the first encoded data packet and the third mapping relationship. In this way, the obtained first network coding mode can be well associated with the quantity information of the first encoded data packet, providing high accuracy.

Example Sixteen:

There are multiple value ranges for the quantity of first encoded data packets. There is no intersection between any two of the value ranges. The network coding modes used by any two of the value ranges are different. The multiple value ranges include at least two value ranges. In an embodiment, the network coding mode is determined according to the value of the quantity n of first encoded data packets, i.e., a mapping relationship $g: n \rightarrow Method$ exists between the network coding mode and n. When the network coding mode is RLNC, the quantity of first encoded data packets supported by the network coding mode is defined as k8. When the network coding mode is RS coding, the quantity of first encoded data packets supported by the network coding mode is defined as k9. When the network coding mode is Raptor Q coding, the quantity of first encoded data packets supported by the network coding mode is defined as k10.

In an example, k8 is less than k9. In an example, k9 is less than k10. In an example, k8 is less than k9, and k9 is less than k10. In an example, a maximum value of k8 is equal to an integer from 24 to 40, and a maximum value of k9 is equal to an integer from 240 to 270.

In an example, the network coding modes include RLNC, RS coding, and Raptor Q coding, the maximum value of k8 is equal to 32, and the maximum value of k9 is equal to 256. A value range of n corresponding to RLNC is greater than 0 and less than or equal to 32. In this range, RLNC has higher coding and decoding throughput. A value range of n corresponding to RS coding is greater than 32 and less than or equal to 256. In this range, RS coding has higher reliability. A value range of n corresponding to Raptor Q coding is greater than 256. In this range, Raptor Q coding supports more encoded data packets. The multiple value ranges are not limited to the values described above, and may also be equal to other values.

In an embodiment, the network coding modes in this example are not limited to RLNC, RS coding, and Raptor Q coding, but may include, but not limited to, at least two of: LT coding, Raptor coding, Raptor Q coding, RS coding, LNC, RLNC, and FNC.

In an embodiment of the present disclosure, when the first network coding parameter includes the quantity information of the redundant data packet, S110 is further described, and S110 may include, but not limited to, a following step S1104.

At S1104, when a fourth mapping relationship between at least two preset network coding modes and the quantity information of the redundant data packet is determined, the first network coding mode is selected from the preset network coding modes according to the quantity information of the redundant data packet and the fourth mapping relationship, where the fourth mapping relationship is used to characterize a quantity of redundant data packets supported by each of the preset network coding modes.

In an embodiment, the fourth mapping relationship is used to characterize a quantity of redundant data packets supported by each of the preset network coding modes.

In this step, the fourth mapping relationship between the preset network coding modes and the quantity information of the redundant data packet is determined, and the first network coding mode can be selected from the preset network coding modes according to the quantity information of the redundant data packet and the fourth mapping relationship. In this way, the obtained first network coding mode can be well associated with the quantity information of the redundant data packet, providing high accuracy.

Example Seventeen:

There are multiple value ranges for the quantity of redundant data packets. There is no intersection between any two of the value ranges. The network coding modes used by any two of the value ranges are different. The multiple value ranges include at least two value ranges. In an embodiment, the network coding mode is determined according to the value of the quantity r of redundant data packets, i.e., a mapping relationship $g : r \rightarrow Method$ exists between the network coding mode and r. When the network coding mode is Raptor Q coding, the quantity of redundant data packets supported by the network coding mode is defined as k11. When the network coding mode is FNC, the quantity of redundant data packets supported by the network coding mode is defined as k12. In an example, k11 is less than k12. In an example, a maximum value of k11 is equal to an integer from 16 to 48.

In an example, the network coding modes include Raptor Q coding and FNC, and the maximum value of k11 is equal to 32. In the case of sending k source data packets with a reliability requirement not lower than Pr, Raptor Q coding can meet the reliability requirement by receiving fewer redundant data packets as compared with FNC. A value range of r corresponding to Raptor Q coding is greater than 0 and less than or equal to 32. A value range of r corresponding to FNC is greater than 32. The multiple value ranges are not limited to the values described above, and may also be equal to other values.

In an embodiment, the network coding modes in this example are not limited to Raptor Q coding and FNC, but may include, but not limited to, at least two of: LT coding, Raptor coding, Raptor Q coding, RS coding, LNC, RLNC, and FNC.

In an embodiment of the present disclosure, when the first network coding parameter includes the code rate, S110 is further described, and S110 may include, but not limited to, a following step S1105.

At S1105, when a fifth mapping relationship between at least two preset network coding modes and the code rate is determined, the first network coding mode is selected from the preset network coding modes according to the code rate and the fifth mapping relationship.

In an embodiment, the fifth mapping relationship is used to characterize the code rate supported by each of the preset network coding modes.

In this step, the fifth mapping relationship between the preset network coding modes and the code rate is determined, and the first network coding mode can be selected from the preset network coding modes according to the code rate and the fifth mapping relationship. In this way, the obtained first network coding mode can be well associated with the code rate, providing high accuracy.

Example Eighteen:

The code rate R is a real number greater than 0 and less than 1. The code rate is an element in a code rate set CoderateSet. The code rate set CoderateSet includes A1 code rates $Coderate_i$, where i is an integer from 0 to A1-1, and A1 is an integer greater than 0.

In an embodiment, the network coding mode is determined according to the value of the code rate, i.e., a mapping relationship $g : R \rightarrow Method$ exists between the network coding mode and the code rate R. When the network coding mode is RLNC, the code rate supported by the network coding mode is defined as k13. When the network coding mode is FNC, the code rate supported by the network coding mode is defined as k14. When the network coding mode is Raptor Q coding, the code rate supported by the network coding mode is defined as k15. When the network coding mode is RS coding, the code rate supported by the network coding mode is defined as k16. In an example, k13 is less than k14. In an example, k14 is less than k15. In an example, k15 is less than k16. In an example, k13 is less than k14, and k14 is less than k15. In an example, k13 is less than k14, k14 is less than k15, and k15 is less than k16. In an example, a maximum value of k13 is equal to a real number from 3/16 to 5/16, a maximum value of k14 is equal to a real number from 7/16 to 9/16, and a maximum value of k15 is equal to a real number from 11/16 to 13/16.

In an example, as shown in FIG. 16, the network coding modes include RLNC, FNC, Raptor Q coding, and RS coding, the maximum value of k13 is equal to 1/4, the maximum value of k14 is equal to 1/2, and the maximum value of k15 is equal to 3/4. A code rate range 1002 corresponding to RLNC is greater than 0 and less than or equal to 1/4. In this range, RLNC has the characteristics of low code rate and a large quantity of redundant encoded data packets, ensuring that the reliability requirement is met. A code rate range 1004 corresponding to FNC is greater than 1/4 and less than or equal to 1/2. In this range, compared with RLNC, FNC can meet the reliability requirement by receiving fewer redundant data packets. Therefore, the code rate range corresponding to FNC is higher than that corresponding to RLNC. A code rate range 1006 corresponding to Raptor Q coding is greater than 1/2 and less than or equal to 3/4. In this range, Raptor Q coding can meet the reliability requirement by receiving fewer redundant data packets as compared with FNC. Therefore, the code rate range corresponding to Raptor Q coding is higher than that corresponding to FNC. A code rate range 1008 corresponding to RS coding is greater than 3/4. In this range, RS coding can meet the reliability requirement by receiving fewer redundant data packets as compared with Raptor Q coding. Therefore, the code rate range corresponding to RS coding is higher than that corresponding to Raptor Q coding. The multiple value ranges are not limited to the values described above, and may also be equal to other values.

In an embodiment, the network coding modes in this example are not limited to RLNC, FNC, Raptor Q coding, and RS coding, but may include, but not limited to, at least two of: LT coding, Raptor coding, Raptor Q coding, RS coding, LNC, RLNC, and FNC.

In an embodiment of the present disclosure, when the first network coding parameter includes the code rate and the quantity information of the source data packet, S110 is further described, and S110 may include, but not limited to, at least one of:

when a sixth mapping relationship between at least two network coding mode subsets and the code rate is determined, selecting a target network coding mode subset from the network coding mode subsets according to the code rate and the sixth mapping relationship, and selecting a preset network coding mode from the target network coding mode subset as the first network coding mode according to the quantity information of the source data packet, where the sixth mapping relationship is used to characterize a range of the code rate supported by each of the network coding mode subsets, and each of the network coding mode subsets includes a plurality of preset network coding modes; or

when a seventh mapping relationship between at least two preset network coding modes, the code rate, and the quantity information of the source data packet is determined, selecting the first network coding mode from the preset network coding modes according to the code rate, the quantity information of the source data packet, and the seventh mapping relationship, where the seventh mapping relationship is used to characterize a range of the code rate and a range of a quantity of source data packets that are supported by each of the preset network coding modes.

In this step, the sixth mapping relationship between the preset network coding modes and the code rate or the seventh mapping relationship between the network coding modes, the code rate, and the quantity information of the source data packet is determined, and the first network coding mode can be selected from the preset network coding modes according to the corresponding mapping relationship. In this way, the obtained first network coding mode can be well associated with the code rate and the quantity information of the source data packet, providing high accuracy.

Example Nineteen:

For the code rate and the quantity information of the source data packet, there are multiple two-dimensional value spaces. There is no intersection between any two of the value spaces. The network coding modes used by any two of the value spaces are different. The multiple value spaces include at least two value spaces. The code rate R is a real number greater than 0 and less than 1, and k is a positive integer.

In an embodiment, the network coding mode is determined according to the value of the quantity k of source data packets and the value of the code rate R, i.e., a mapping relationship $g : (k, R) \rightarrow Method$ exists between the network coding mode, k, and R.

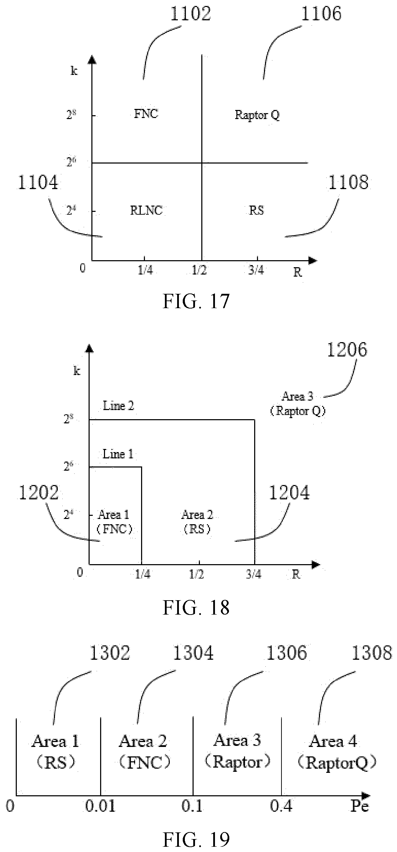

In an example, as shown in FIG. 17, the code rate R is a real number greater than 0 and less than 1, and k is a positive integer. When the code rate range is greater than 0 and less than or equal to 1/2, it corresponds to a network coding mode subset {RLNC, FNC}. When the code rate range is greater than 1/2 and less than 1, it corresponds to a network coding mode subset {Raptor Q, RS}. Then, the network coding mode is determined from the subset according to the quantity k of source data packets. An area 1102 corresponds to FNC, an area 1104 corresponds to RLNC, an area 1106 corresponds to Raptor Q coding, and an area 1108 corresponds to RS coding. According to the characteristics of the network coding mode, the reliability requirement is ensured by sending fewer redundant encoded data packets, thereby striking a balance between the reliability, the throughput, and the complexity. The multiple value ranges are not limited to the values described above, and may also be equal to other values.

In an example, as shown in FIG. 18, the network coding modes include FNC, RS coding, and Raptor Q coding. FNC corresponds to a two-dimensional value space 1202 where the code rate is greater than 0 and less than or equal to 1/4 and the quantity of source data packets is greater than 0 and less than or equal to 32. In this range, FNC has the characteristics of low code rate and a large quantity of redundant encoded data packets, ensuring that the reliability requirement is met. RS coding corresponds to a two-dimensional value space 1204 where "the code rate is greater than 1/4 or the quantity of source data packets is greater than 32" and "the code rate is less than or equal to 3/4 or the quantity of source data packets is less than or equal to 256". In this range, RS coding has higher reliability and can adapt to higher erasure rates. Raptor Q corresponds to a two-dimensional value space 1206 where the code rate is greater than 3/4 and less than 1 or the quantity of source data packets is greater than 256. In this range, Raptor Q coding supports more source data packets, and the code rate greater than 3/4 allows for the generation of more encoded data packets, thereby improving the reliability. The multiple value ranges are not limited to the values described above, and may also be equal to other values.

In an embodiment, the network coding modes in this example are not limited to RLNC, FNC, Raptor Q coding, and RS coding, but may include, but not limited to, at least two of: LT coding, Raptor coding, Raptor Q coding, RS coding, LNC, RLNC, and FNC.

In an embodiment of the present disclosure, when the first network coding parameter includes the throughput, S110 is further described, and S110 may include, but not limited to, a following step S1106.

At S1106, when an eighth mapping relationship between at least two preset network coding modes and the throughput is determined, the first network coding mode is selected from the preset network coding modes according to the throughput and the eighth mapping relationship.

In an embodiment, the eighth mapping relationship is used to characterize the throughput supported by each of the preset network coding modes.

In this step, the eighth mapping relationship between the preset network coding modes and the throughput is determined, and the first network coding mode can be selected from the preset network coding modes according to the throughput and the eighth mapping relationship. In this way, the obtained first network coding mode can be well associated with the throughput, providing high accuracy.

Example Twenty:

There are multiple value ranges for the throughput. There is no intersection between any two of the value ranges. The network coding modes used by any two of the value ranges are different. The multiple value ranges include at least two value ranges. In an embodiment, the network coding mode is determined according to the range within which the value of a throughput requirement TP falls, i.e., a mapping relationship $g : \text{TP} \to Method$ exists between the network coding mode and the throughput requirement. When the network coding mode is RS coding, the throughput requirement supported by the network coding mode is defined as k17. When the network coding mode is Raptor Q coding, the throughput requirement supported by the network coding mode is defined as k18. When the network coding mode is RLNC, the throughput requirement supported by the network coding mode is defined as k19. In an example, k17 is less than k18. In an example, k18 is less than k19. In an example, k17 is less than k18, and k18 is less than k19. In an example, a maximum value of k17 is equal to a real number from 500 Mbps to 2 Gbps, and a maximum value of k18 is equal to a real number from 5 Gbps to 20 Gbps.

In an example, the network coding modes include RS coding, Raptor Q coding, and RLNC, the maximum value of k17 is equal to 1 Gbps, and the maximum value of k18 is equal to 10 Gbps. A value range of TP corresponding to RS coding is greater than 0 and less than or equal to 1 Gbps. A value range of TP corresponding to Raptor Q coding is greater than 1 Gbps and less than or equal to 10 Gbps. RLNC has low encoding and decoding complexity, and can meet higher throughput requirements. A value range of TP corresponding to RLNC is greater than 10 Gbps. The multiple value ranges are not limited to the values described above, and may also be equal to other values.

In an embodiment, the network coding modes in this example are not limited to RS coding, Raptor Q coding, and RLNC, but may include, but not limited to, at least two of: LT coding, Raptor coding, Raptor Q coding, RS coding, LNC, RLNC, and FNC.

In an embodiment of the present disclosure, when the first network coding parameter includes the reliability requirement, S110 is further described, and S110 may include, but not limited to, a following step S1107.

At S1107, when a ninth mapping relationship between at least two preset network coding modes and the reliability requirement is determined, the first network coding mode is selected from the preset network coding modes according to the reliability requirement and the ninth mapping relationship.

In an embodiment, the ninth mapping relationship is used to characterize the reliability requirement supported by each of the preset network coding modes.

In this step, the ninth mapping relationship between the preset network coding modes and the reliability requirement is determined, and the first network coding mode can be selected from the preset network coding modes according to the reliability requirement and the ninth mapping relationship. In this way, the obtained first network coding mode can be well associated with the reliability requirement, providing high accuracy.

Example Twenty-one:

There are multiple value ranges for the reliability requirement. There is no intersection between any two of the value ranges. The network coding modes used by any two of the value ranges are different. The multiple value ranges include at least two value ranges. In an embodiment, the network coding mode is determined according to the range within which the value of the reliability requirement falls, i.e., a mapping relationship $g : \text{Pr} \rightarrow Method$ exists between the network coding mode and the reliability requirement Pr. When the network coding mode is RLNC, the reliability requirement supported by the network coding mode is defined as k20. When the network coding mode is Raptor Q coding, the reliability requirement supported by the network coding mode is defined as k21. When the network coding mode is RS coding, the reliability requirement supported by the network coding mode is defined as k22. In an example, k20 is less than k21. In an example, k21 is less than k22. In an example, k20 is less than k21, and k21 is less than k22. In an example, a maximum value of k20 is equal to a real number from 0.9 to 0.995, and a maximum value of k21 is equal to a real number from 0.999 to 0.99995.

In an example, the network coding modes include RLNC, Raptor Q coding, and RS coding, the maximum value of k20 is equal to 0.99, and the maximum value of k21 is equal to 0.9999. In the case of receiving the same quantity of redundant encoded data packets, RS coding has the highest decoding success probability and RLNC has the lowest decoding success probability. In an example, a value range of Pr corresponding to RLNC is greater than 0 and less than or equal to 0.99, a value range of Pr corresponding to Raptor Q coding is greater than 0.99 and less than or equal to 0.9999, and a value range of Pr corresponding to RS coding is greater than 0.9999. The multiple value ranges are not limited to the values described above, and may also be equal to other values.

In an embodiment, the network coding modes in this example are not limited to RLNC, Raptor Q coding, and RS coding, but may include, but not limited to, at least two of: LT coding, Raptor coding, Raptor Q coding, RS coding, LNC, RLNC, and FNC.

In an embodiment of the present disclosure, when the first network coding parameter includes the erasure rate, S110 is further described, and S110 may include, but not limited to, a following step S1108.

At S1108, when a tenth mapping relationship between at least two preset network coding modes and the erasure rate is determined, the first network coding mode is selected from the preset network coding modes according to the erasure rate and the tenth mapping relationship.

In an embodiment, the tenth mapping relationship is used to characterize the erasure rate supported by each of the preset network coding modes.

In this step, the tenth mapping relationship between the preset network coding modes and the erasure rate is determined, and the first network coding mode can be selected from the preset network coding modes according to the erasure rate and the tenth mapping relationship. In this way, the obtained first network coding mode can be well associated with the erasure rate, providing high accuracy.

Example Twenty-two:

There are multiple value ranges for the erasure rate. There is no intersection between any two of the value ranges. The network coding modes used by any two of the value ranges are different. The multiple value ranges include at least two value ranges. In an embodiment, the network coding mode is determined according to the range within which the value of the erasure rate falls, i.e., a mapping relationship $g : \text{Pe} \rightarrow Method$ exists between the network coding mode and the erasure rate Pe. When the network coding mode is RS coding, the erasure rate supported by the network coding mode is defined as k23. When the network coding mode is FNC, the erasure rate supported by the network coding mode is defined as k24. When the network coding mode is Raptor coding, the erasure rate supported by the network coding mode is defined as k25. When the network coding mode is Raptor Q coding, the erasure rate supported by the network coding mode is defined as k26. In an example, k23 is less than k24. In an example, k24 is less than k25. In an example, k25 is less than k26. In an example, k23 is less than k24, and k24 is less than k25. In an example, k23 is less than k24, k24 is less than k25, and k25 is less than k26. In an example, a maximum value of k23 is equal to a real number from 0.005 to 0.02, a maximum value of k24 is equal to a real number from 0.05 to 0.2, and a maximum value of k25 is equal to a real number from 0.3 to 0.5.

In an example, as shown in FIG. 19, the network coding modes include RS coding, FNC, Raptor coding, and Raptor Q coding, the maximum value of k23 is equal to 0.01, the maximum value of k24 is equal to 0.1, and the maximum value of k25 is equal to 0.4. A value range 1302 of Pe corresponding to RS coding is greater than 0 and less than or equal to 0.01, a value range 1304 of Pe corresponding to FNC is greater than 0.01 and less than or equal to 0.1, a value range 1306 of Pe corresponding to Raptor coding is greater than 0.1 and less than or equal to 0.4, and a value range 1308 of Pe corresponding to Raptor Q coding is greater than 0.4 and less than 1. Through the setting of the ranges, more encoded data packets are generated to meet the reliability requirement in the case of high erasure rate, and fewer encoded data packets are generated in the case of low erasure rate. In this way, resource consumption is reduced while meeting the reliability requirement. The multiple value ranges are not limited to the values described above, and may also be equal to other values.

In an embodiment, the network coding modes in this example are not limited to RS coding, FNC, Raptor coding, and Raptor Q coding, but may include, but not limited to, at least two of: LT coding, Raptor coding, Raptor Q coding, RS coding, LNC, RLNC, and FNC.

In an embodiment of the present disclosure, when the first network coding parameter includes the size information of the source data packet and the quantity information of the source data packet, S110 is further described, and S110 may include, but not limited to, a following step S1109.

At S1109, when an eleventh mapping relationship between at least two preset network coding modes, the size information of the source data packet, and the quantity information of the source data packet is determined, the first network coding mode is selected from the preset network coding modes according to the size information of the source data packet, the quantity information of the source data packet, and the eleventh mapping relationship.

In an embodiment, the eleventh mapping relationship is used to characterize a range of a size of the source data packet and a range of a quantity of source data packets that are supported by each of the preset network coding modes.

In this step, the eleventh mapping relationship between the preset network coding modes, the size information of the source data packet, and the quantity information of the source data packet is determined, and the first network coding mode can be selected from the preset network coding modes according to the size information of the source data packet, the quantity information of the source data packet, and the eleventh mapping relationship. In this way, the obtained first network coding mode can be well associated with the size information of the source data packet and the quantity information of the source data packet, providing high accuracy.

Example Twenty-three:

For the size information of the source data packet and the quantity information of the source data packet, there are multiple two-dimensional value spaces. There is no intersection between any two of the value spaces. The network coding modes used by any two of the value spaces are different. The multiple value spaces include at least two value spaces. In an embodiment, the network coding mode is determined according to the value of the quantity k of source data packets and the value of the source data packet size T, i.e., a mapping relationship $g : (k, T) \rightarrow Method$ exists between the network coding mode, k, and T.

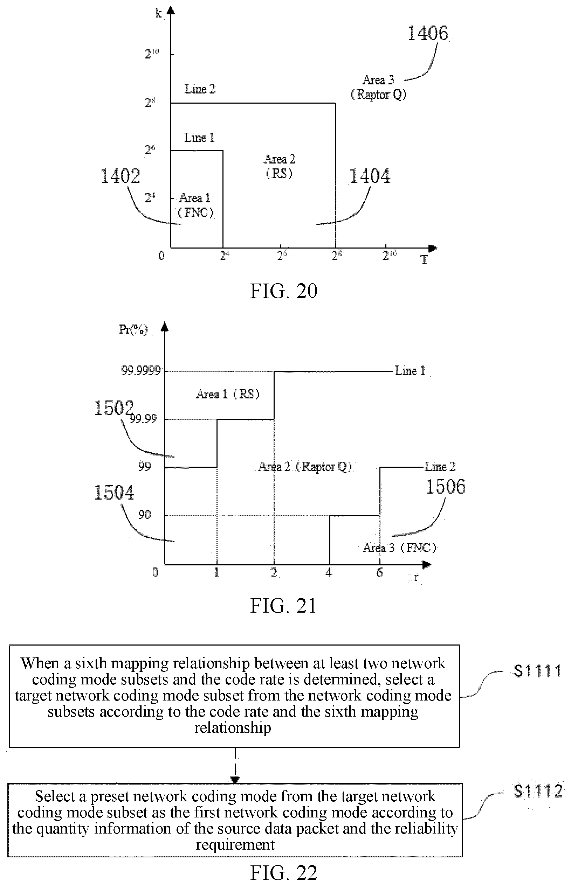

In an example, as shown in FIG. 20, the network coding modes include FNC, RS coding, and Raptor Q coding. FNC corresponds to a two-dimensional value space 1402 where "the source data packet size is greater than 0 and less than or equal to 16" and "the quantity of source data packets is greater than 0 and less than or equal to 32". RS coding corresponds to a two-dimensional value space 1404 where "the source data packet size is greater than 16 or the quantity of source data packets is greater than 32" and "the source data packet size is less than or equal to 256 or the quantity of source data packets is less than or equal to 256". Raptor Q coding corresponds to a two-dimensional value space 1406 where "the source data packet size is greater than 256" and "the quantity of source data packets is greater than 256". Through the setting of the ranges, higher encoding and decoding throughput can be achieved when the quantity of source data packets is small, and higher reliability can be achieved when the quantity of source data packets is large. The multiple value ranges are not limited to the values described above, and may also be equal to other values.

In an embodiment, the network coding modes in this example are not limited to FNC, RS coding, and Raptor Q coding, but may include, but not limited to, at least two of: LT coding, Raptor coding, Raptor Q coding, RS coding, LNC, RLNC, and FNC.

In an embodiment of the present disclosure, when the first network coding parameter includes the quantity information of the redundant data packet and the reliability requirement, S110 is further described, and S110 may include, but not limited to, a following step S1110.

At S1110, when a twelfth mapping relationship between at least two preset network coding modes, the quantity information of the redundant data packet, and the reliability requirement is determined, the first network coding mode is selected from the preset network coding modes according to the quantity information of the redundant data packet, the reliability requirement, and the twelfth mapping relationship.

In an embodiment, the twelfth mapping relationship is used to characterize a quantity of redundant data packets and the reliability requirement that are supported by each of the preset network coding modes.

In this step, the twelfth mapping relationship between the preset network coding modes, the quantity information of the redundant data packet, and the reliability requirement is determined, and the first network coding mode can be selected from the preset network coding modes according to the quantity information of the redundant data packet, the reliability requirement, and the twelfth mapping relationship. In this way, the obtained first network coding mode can be well associated with the quantity information of the redundant data packet and the reliability requirement, providing high accuracy.

Example Twenty-four:

For the quantity information of the redundant data packet and the reliability requirement, there are multiple two-dimensional value spaces. There is no intersection between any two of the value spaces. The network coding modes used by any two of the value spaces are different. The multiple value spaces include at least two value spaces. In an embodiment, the network coding mode is determined according to the value of the quantity r of redundant data packets and the value of the reliability Pr, i.e., a mapping relationship $g : (r, \mathrm{Pr}) \rightarrow Method$ exists between the network coding mode, r, and Pr. In an example, as shown in FIG. 21, the network coding modes include RS coding, Raptor Q coding, and FNC. RS coding corresponds to a two-dimensional value space 1502 (i.e., a two-dimensional value space above Line 1), Raptor Q coding corresponds to a two-dimensional value space 1504 (i.e., a two-dimensional value space between Line 1 and Line 2), and FNC corresponds to a two-dimensional value space 1506 (i.e., a two-dimensional value space below Line 2). Through the setting of the ranges, the reliability requirement can be met with fewer redundant data packets, thereby reducing the consumption of transmission resources. The multiple value ranges are not limited to the values described above, and may also be equal to other values.

In an embodiment, the network coding modes in this example are not limited to RS coding, Raptor Q coding, and FNC, but may include, but not limited to, at least two of: LT coding, Raptor coding, Raptor Q coding, RS coding, LNC, RLNC, and FNC.

As shown in FIG. 22, in an embodiment of the present disclosure, when the first network coding parameter includes the code rate, the quantity information of the source data packet, and the reliability requirement, S110 is further described, and S110 may include, but not limited to, the following steps S1111 to S1112.

At S1111, when a sixth mapping relationship between at least two network coding mode subsets and the code rate is determined, a target network coding mode subset is selected from the network coding mode subsets according to the code rate and the sixth mapping relationship, where the sixth mapping relationship is used to characterize a range of the code rate supported by each of the network coding mode subsets, and each of the network coding mode subsets includes a plurality of preset network coding modes.

At S1112, a preset network coding mode is selected from the target network coding mode subset as the first network coding mode according to the quantity information of the source data packet and the reliability requirement.

In this step, the target network coding mode subset can be selected according to the determined sixth mapping relationship between the preset network coding mode subsets and the code rate, and a preset network coding mode can be selected from the target network coding mode subset as the first network coding mode according to the quantity information of the source data packet and the reliability requirement. In this way, the obtained first network coding mode can be well associated with the code rate, the quantity information of the source data packet, and the reliability requirement, providing high accuracy.

Example Twenty-five:

A mapping relationship exists between network coding modes and combinations of R, k, and Pr. In an example, as shown in Table 3, when the code rate is greater than 0 and less than or equal to 1/2, it corresponds to network coding modes of FNC and RLNC, and when the code rate is greater than 1/2 and less than 1, it corresponds to network coding modes of RS coding and Raptor Q coding. Then, the network coding mode is determined according to the values of Pr and k. Through the setting of the ranges, the generation of redundant encoded data packets can be reduced while meeting the reliability requirement, thereby reducing the consumption of transmission resources. The multiple value ranges are not limited to the values described above, and may also be equal to other values.

In an embodiment, the network coding modes in this example are not limited to FNC, RLNC, RS coding, and Raptor coding, but may include, but not limited to, at least two of: LT coding, Raptor coding, Raptor Q coding, RS coding, LNC, RLNC, and FNC.

Table 3 Example table of mapping relationship between coding modes and combinations of the code rate R, the quantity k of source data packets, and the reliability Pr

| - | | $0 < k \le 2^8$ | $k > 2^8$ |
|---|---|---|---|
| 0 < R ≤ 1/2 | $Pr \le 10^{-6}$ | FNC | FNC |
| | $10^{-6} < Pr \le 10^{-3}$ | FNC | RLNC |
| | $10^{-3} < Pr \le 1$ | RLNC | RLNC |
| 1/2 < R < 1 | $Pr \le 10^{-6}$ | RS | Raptor Q |
| | $10^{-6} < Pr \le 10^{-3}$ | RS | Raptor Q |
| | $10^{-3} < Pr \le 1$ | RS | Raptor Q |

In an embodiment of the present disclosure, when the first network coding parameter includes the channel state information, S110 is further described, and S110 may include, but not limited to, at least one of:

when the channel state information includes channel quality indication information, determining the first network coding mode according to an index value of the channel quality indication information;

when the channel state information includes rank indication information, determining the first network coding mode according to a value of the rank indication information; or

when the channel state information includes precoding matrix indication information, determining the first network coding mode according to an index value of the precoding matrix indication information.

In this step, the specific channel state information is determined, and the corresponding matching network coding mode can be selected according to the determined specific channel state information.

Example Twenty-six:

In an embodiment, the network coding method is determined according to a channel quality indication. The corresponding network coding modes include RS coding, Raptor Q coding, and RLNC. A network coding mode to be used is determined by the channel quality indication. For example, when an index value of the channel quality indication is an integer of 1 to 5, the network coding mode is RS coding; when the index value of the channel quality indication is an integer of 6 to 10, the network coding mode is Raptor Q coding; and when the index value of the channel quality indication is an integer of 11 to 15, the network coding mode is RLNC. In this way, when the channel quality is unsatisfactory, RS coding with higher performance is used to improve reliability; while when the channel quality is satisfactory, RLNC with low encoding and decoding complexity is used to improve throughput.

In an embodiment, the network coding method is determined according to a rank indication. The corresponding network coding modes include RS coding, Raptor Q coding, and RLNC. A network coding mode to be used is determined by the rank indication. For example, when the rank indication is equal to 1 or 2, the network coding mode is RS coding; when the rank indication is equal to 3, the network coding mode is Raptor Q coding; and when the rank indication is equal to 4, the network coding mode is RLNC. In this way, when the value of the rank indication is small, RS coding with higher performance is used to improve reliability; while when the value of the rank indication is large, RLNC is used to improve throughput.

In an embodiment, the network coding method is determined according to a precoding matrix indication. The corresponding network coding modes include RS coding, Raptor Q coding, and RLNC. A network coding mode to be used is determined by the precoding matrix indication. For example, for a single-layer transmission using four antenna ports with transform precoding enabled, the network coding mode is RS coding when an index value of a Transmit Precoding Matrix Indication (TPMI) is an integer of 0 to 7, is Raptor Q coding when the index value of the TPMI is an integer of 8 to 15, and is RLNC when the index value of the TPMI is an integer of 16 to 27.

In an embodiment, the network coding modes in this example are not limited to RS coding, Raptor Q coding, and RLNC, but may include, but not limited to, at least two of: LT coding, Raptor coding, Raptor Q coding, RS coding, LNC, RLNC, and FNC.

Example Twenty-seven:

Network coding is performed on the source data packets to generate first encoded data packets. The source data packets may be data packets of one of the following sublayers in a Radio Interface Protocol stack: a PDCP layer, an RLC layer, a MAC layer, or a physical layer, where a first transmission node serves as a transmitting end, and a second transmission node serves as a first receiving end.

In an embodiment, the network coding mode is at least a functional module of one of the following sublayers in a Radio Interface Protocol stack: a PDCP layer, an RLC layer, a MAC layer, or a physical layer. In addition, any two of the sublayers in the Radio Interface Protocol stack such as the PDCP layer, the RLC layer, the MAC layer, and the physical layer correspond to different network coding modes. For example, Raptor Q coding is used in the PDCP layer, RS coding is used in the MAC layer, and whether Raptor Q coding is performed in the PDCP layer is controlled through higher-layer signaling, and whether RS coding is performed in the MAC layer is controlled through higher-layer signaling.

In an embodiment, the source packets are SDU data packets of the PDCP layer. As a functional module in the PDCP layer, network coding is used to encode the SDU data packets.

Specific scenario one:

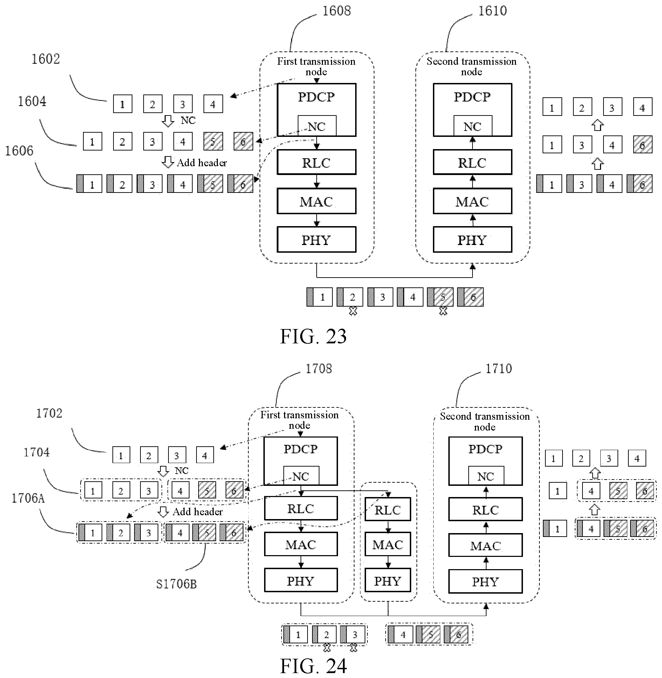

As shown in FIG. 23, as a functional module in a PDCP layer of a first transmission node 1608, network coding is used to encode PDCP SDUs 1602. The quantity of source data packets is defined as k, and k is an integer greater than 0. In an example, k=4. The network coding is used to encode the source data packets to obtain n encoded data packets 1604, where n is an integer greater than k. In an example, n=6. Then, a PDCP header is added to the encoded data packets to obtain PDCP PDUs 1606, which are transmitted to an RLC layer of the first transmission node via an RLC channel. In an example, a second transmission node 1610 receives data packets 1, 3, 4, and 6. Data packets 2 and 5 are erased during transmission. The second transmission node removes the PDCP header from the received data packets at a PDCP layer thereof, and performs decoding to restore the source data packets. White boxes in 1602 represent the source data packets. Gray parts of boxes in 1606 represent data packet headers. Slashed parts of boxes in 1604 and 1606 represent redundant data packets.

Specific scenario two:

As shown in FIG. 24, as a functional module in a PDCP layer of a first transmission node 1708, network coding is used to encode PDCP SDUs 1702. The quantity of source data packets is defined as k, and k is an integer greater than 0. In an example, k=4. The network coding is used to encode the source data packets to obtain n encoded data packets 1704, where n is an integer greater than k. In an example, n=6. Then, a PDCP header is added to the encoded data packets to obtain PDCP PDUs 1706A and 1706B. In a Dual Connectivity (DC) scenario, the encoded PDCP PDUs are split according to Channel State Information-Reference Signal (CSI-RS), Downlink Control Information (DCI), and other channel state information, and a cell with satisfactory channel quality or an idle cell carry more data packets. In an example, four PDCP SDUs 1702 are network-coded to obtain six encoded data packets 1704. Then, a PDCP header is added to the encoded data packets to obtain six PDCP PDUs. Three PDCP PDUs 1706A are transmitted through a primary cell, and three PDCP PDUs 1706B are transmitted through a secondary cell. A second transmission node receives the data packet 1 transmitted through the primary cell and the data packets 4, 5, and 6 transmitted through the secondary cell, removes the PDCP header from the received data packets at a PDCP layer of the second transmission node, and performs decoding to restore the source data packets.

Specific scenario three:

As a functional module in a PDCP layer of a first transmission node, network coding is used to encode PDCP SDUs. The quantity of source data packets is defined as k, and k is an integer greater than 0. In an example, k=4. The network coding is used to encode the source data packets to obtain n encoded data packets, where n is an integer greater than k. In an example, n=6. Then, a PDCP header is added to the encoded data packets to obtain PDCP PDUs. In a DC scenario, each cell transmits the PDCP PDUs after PDCP repetition. For example, four PDCP SDUs are network-coded to obtain six encoded data packets, and a PDCP header is added to the encoded data packets to obtain six PDCP PDUs. In this case, after PDCP repetition, six PDCP PDUs are transmitted through a primary cell, and six PDCP PDUs identical to those transmitted through the primary cell are transmitted through a secondary cell.

Specific scenario four:

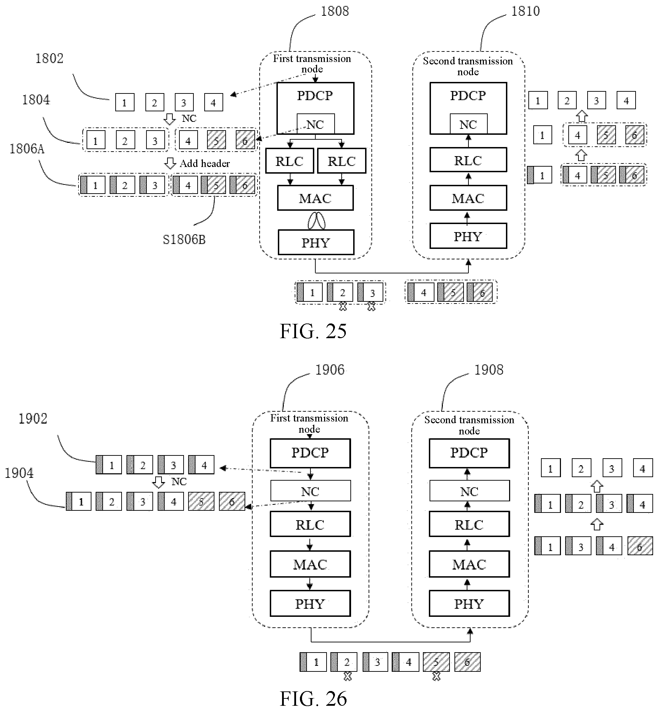

As shown in FIG. 25, as a functional module in a PDCP layer of a first transmission node 1808, network coding is used to encode PDCP SDUs 1802. The quantity of source data packets is defined as k, and k is an integer greater than 0. In an example, k=4. The network coding is used to encode the source data packets to obtain n encoded data packets 1804, where n is an integer greater than k. In an example, n=6. Then, a PDCP header is added to the encoded data packets to obtain PDCP PDUs 1806A and 1806B. In a Carrier Aggregation (CA) scenario, the encoded PDCP PDUs are split according to CSI-RS, DCI, and other channel state information, and are sent through different carriers. In the figure, four PDCP SDUs 1802 are network-coded to obtain six encoded data packets 1804, and then a PDCP header is added to the encoded data packets to obtain six PDCP PDUs. Three PDCP PDUs 1806A are transmitted through a first carrier, and three PDCP PDUs 1806B are transmitted through a second carrier. The first carrier and the second carrier are merely used for distinguishing different carriers, and do not indicate any particular sequence. A second transmission node receives the data packet 1 transmitted through the first carrier and the data packets 4, 5, and 6 transmitted through the second carrier, removes the PDCP header from the received data packets at a PDCP layer of the second transmission node, and performs decoding to restore the source data packets.

Specific scenario five:

As a functional module in a PDCP layer of a first transmission node, network coding is used to encode PDCP SDUs. The quantity of source data packets is defined as k, and k is an integer greater than 0. In an example, k=4. The network coding is used to encode the source data packets to obtain n encoded data packets, where n is an integer greater than k. In an example, n=6. Then, a PDCP header is added to the encoded data packets to obtain PDCP PDUs. In a CA scenario, each carrier transmits PDCP PDU data after PDCP repetition. For example, four PDCP SDUs are network-coded to obtain six encoded data packets, and a PDCP header is added to the encoded data packets to obtain six PDCP PDUs. In this case, after PDCP repetition, six PDCP PDUs are transmitted through a first carrier, and six PDCP PDUs identical to those transmitted through the first carrier are transmitted through a second carrier.

In an embodiment, the source data packets are PDU data packets of the PDCP layer. As shown in FIG. 26, as a sublayer between a PDCP layer and an RLC layer of a first transmission node 1906, network coding is used to encode PDCP PDUs 1902. The quantity of source data packets is defined as k, and k is an integer greater than 0. In an example, k=4. The network coding is used to encode the source data packets to obtain n encoded data packets 1904, where n is an integer greater than k. In an example, n=6. A second transmission node 1908 receives data packets 1, 3, 4, and 6. Data packets 2 and 5 are erased during transmission. The second transmission node performs decoding at an NC sublayer thereof to restore the source data packets.

In an embodiment, the source packets are SDU data packets of the RLC layer. As a functional module in the RLC layer, network coding is used to encode the SDU data packets.

Specific scenario one:

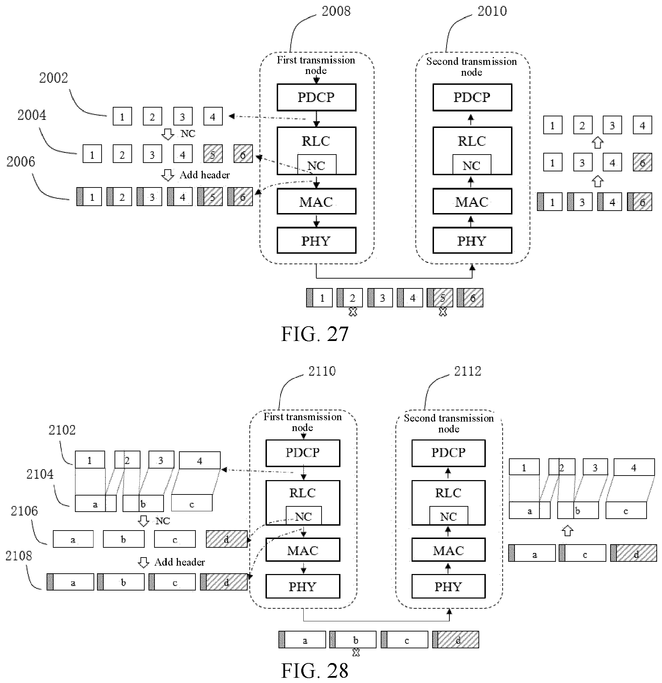

As shown in FIG. 27, as a functional module in an RLC layer of a first transmission node 2008, network coding is used to encode RLC SDUs 2002. The quantity of source data packets is defined as k, and k is an integer greater than 0. In an example, k=4. The network coding is used to encode the source data packets to obtain n encoded data packets 2004, where n is an integer greater than k. In an example, n=6. Then, an RLC header is added to the encoded data packets to obtain RLC PDUs 2006. A second transmission node 2010 receives data packets 1, 3, 4, and 6. Data packets 2 and 5 are erased during transmission. The second transmission node removes the RLC header from the received data packets at an RLC layer thereof and performs decoding to restore the source data packets.

Specific scenario two:

As shown in FIG. 28, as a functional module in an RLC layer of a first transmission node 2110, network coding is used to segment RLC SDUs 2102 to obtain k source data packets 2104 of the same size, where k is an integer greater than 0. In an example, k=3. Then, the network coding is used to encode the source data packets to obtain n encoded data packets 2106, where n is an integer greater than k. In an example, n=4. Then, an RLC header is added to the encoded data packets to obtain RLC PDUs 2108. A second transmission node 2112 receives data packets a, c, and d. A data packet b is erased during transmission. The second transmission node removes the RLC header from the received data packets at an RLC layer thereof and performs decoding to restore the source data packets.

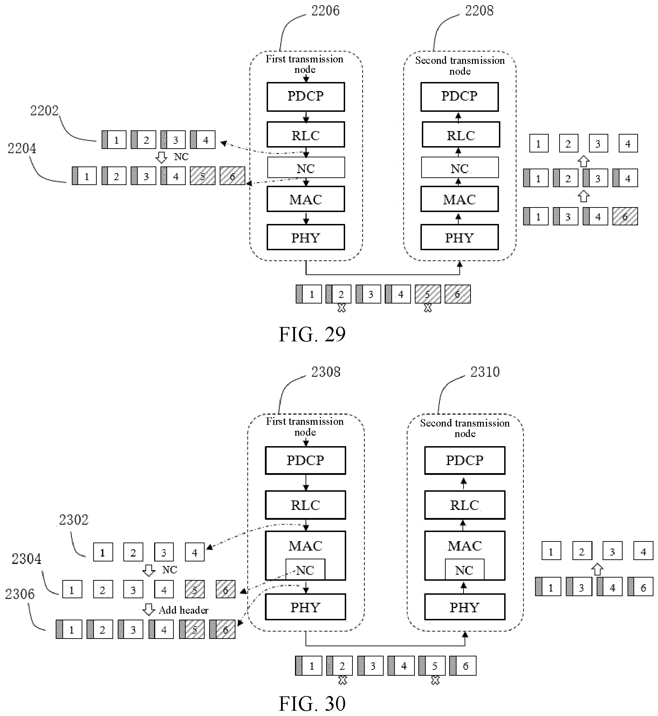

In an embodiment, the source data packets are PDU data packets of the RLC layer. As shown in FIG. 29, as a sublayer between an RLC layer and an MAC layer of a first transmission node 2206, network coding is used to encode RLC PDUs 2202. The quantity of source data packets is defined as k, and k is an integer greater than 0. In an example, k=4. The network coding is used to encode the source data packets to obtain n encoded data packets 2204, where n is an integer greater than k. In an example, n=6. A second transmission node 2208 receives data packets 1, 3, 4, and 6. Data packets 2 and 5 are erased during transmission. The second transmission node performs decoding at an NC sublayer thereof to restore the source data packets.

In an embodiment, the source data packets are SDU data packets of the MAC layer. As shown in FIG. 30, as a functional module in a MAC layer of a first transmission node 2308, network coding is used to encode MAC SDUs 2302. The quantity of source data packets is defined as k, and k is an integer greater than 0. In an example, k=4. The network coding is used to encode the source data packets to obtain n encoded data packets 2304, where n is an integer greater than k. In an example, n=6. Then, a MAC header is added to the encoded data packets to obtain MAC PDUs 2306. A second transmission node 2310 receives data packets 1, 3, 4, and 6. Data packets 2 and 5 are erased during transmission. The second transmission node removes the MAC header from the received data packets at a MAC layer thereof, and performs decoding to restore the source data packets.

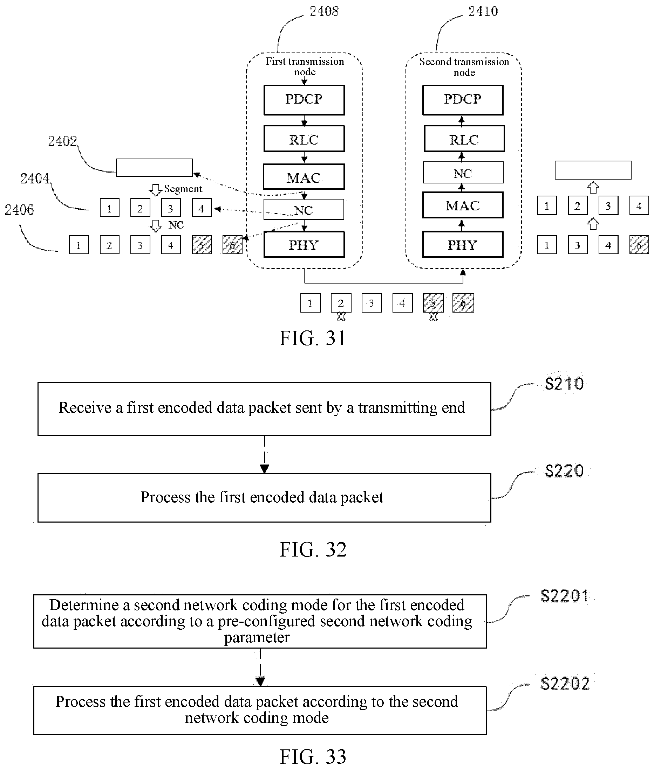

In an embodiment, the source data packets are PDU data of the MAC layer. As shown in FIG. 31, as a sublayer between a MAC layer and a PHY layer of a first transmission node 2408, network coding is used to evenly segment MAC PDUs 2402 to obtain k source data packets 2404, where k is an integer greater than 0. In an example, k=4. Then, the network coding is used to encode the source data packets to obtain n encoded data packets 2406, where n is an integer greater than k. In an example, n=6. A second transmission node 2410 receives encoded data packets 1, 3, 4, and 6. Encoded data packets 2 and 5 are erased during transmission. The second transmission node performs decoding at an NC sublayer thereof to restore the source data packets.

In an embodiment, indices of first encoded data packets in the first network coding parameter are characterized by: being non-negative integers incrementing from i, where i is an integer greater than or equal to 0, and encoding index numbers of n first encoded data packets obtained by encoding k source data packets are {$i$, $i+1$,..., $i+k-1$,$i+k$, $i+k+1$,..., $i+n-1$} in sequence.

In an embodiment, the size of the source data packet in the first network coding parameter is characterized by: being determined by a non-negative integer quantity of Data Units (DUs) and/or a part of one DU. As shown in FIG. 28, a in the source data packet 2104 includes a part of data packet 1 and a part of data packet 2 in 2102. The DU includes one of: a PDCP SDU, a PDCP PDU, an RLC SDU, an RLC PDU, a MAC SDU, or a MAC PDU.

In an embodiment, the encoding matrix G in the first network coding parameter may be determined according to, for example, but not limited to, the network coding mode, the quantity k of source data packets, and the quantity n of first encoded data packets, and the header information of the source data packet does not include the encoding matrix. For example, the network coding mode is RS coding based on a Cauchy matrix, as shown in the following formula. The encoding matrix includes an upper part $I_k$ which is an identity matrix of k*k and a lower part which is a Cauchy matrix of (n-k)*k. The encoding matrix can be determined at the first transmission node and the second transmission node according to the values of k and n.

$$G = \begin{bmatrix} & & I_k & & \\ \dfrac{1}{a_1+b_1} & \dfrac{1}{a_1+b_2} & \dfrac{1}{a_1+b_3} & \cdots & \dfrac{1}{a_1+b_k} \\ \dfrac{1}{a_2+b_1} & \dfrac{1}{a_2+b_2} & \dfrac{1}{a_2+b_3} & \cdots & \dfrac{1}{a_2+b_k} \\ \dfrac{1}{a_3+b_1} & \dfrac{1}{a_3+b_2} & \dfrac{1}{a_3+b_3} & \cdots & \dfrac{1}{a_3+b_k} \\ \vdots & \vdots & \vdots & \ddots & \vdots \\ \dfrac{1}{a_{n-k}+b_1} & \dfrac{1}{a_{n-k}+b_2} & \dfrac{1}{a_{n-k}+b_3} & \cdots & \dfrac{1}{a_{n-k}+b_k} \end{bmatrix}$$

In some embodiments, in control information of the first encoded data packets, the encoding matrix G is determined according to the network coding mode and a random seed, and the header information of the source data packet does not include the encoding matrix. For example, the network coding mode is RLNC, each row or column of the coding matrix is determined according to a random seed, and any two random seeds are not equal. The random seed is determined by at least one of the following parameters: an index of the encoded data packet, the quantity of source data packets, and the quantity of encoded data packets. The first transmission node and the second transmission node determine the encoding matrix by using the same random seed.

At S130, the first encoded data packet is sent to a first receiving end, such that the first receiving end processes the first encoded data packet.

In this step, a transmitting end determines a first network coding mode for a source data packet according to a pre-configured first network coding parameter, performs network coding on the source data packet based on the determined first network coding mode to generate encoded data, and transmits the encoded data to a first receiving end, such that the first receiving end receives sufficient encoded data for processing. That is to say, the transmitting end only needs to send the corresponding encoded data to the first receiving end, and the first receiving end can effectively complete the decoding. Therefore, the delay caused by repeated sending of data packets can be avoided, and the reliability and throughput of data transmission can be improved while reducing physical resource overheads, thereby filling in the technical gap in related methods.

In an embodiment, the processing of the first encoded data packet by the first receiving end includes, but not limited to, decoding, sending, encoding and other operations on the first encoded data packet. The manner in which the first receiving end processes the first encoded data packet will be described in detail in the following related embodiments and will not be detailed here.

FIG. 32 is a flowchart of a data processing method according to another embodiment of the present disclosure. The data processing method may include, but not limited to, the following steps S210 to S220.

At S210, a first encoded data packet sent by a transmitting end is received.

At S220, the first encoded data packet is processed.

The first encoded data packet is obtained by the transmitting end by encoding acquired at least one source data packet according to a first network coding mode for the source data packet. The first network coding mode is determined by the transmitting end according to a pre-configured first network coding parameter.

In an embodiment, the execution entity of the data processing method in this embodiment may be, but not limited to, the first receiving end 120 in the embodiment shown in FIG. 1 or FIG. 2, or those having ordinary skills in the art may be set the corresponding execution entity according to actual application scenarios, which is not limited in this embodiment. To more conveniently describe the application scenarios and principle of the present disclosure, the following related embodiments are described with the first receiving end as the execution entity of the data processing method, but should not be construed as a limitation to the embodiments of the present disclosure.

In this step, a first receiving end receives a first network coding mode determined for a source data packet by a transmitting end according to a pre-configured first network coding parameter, and processes the first encoded data packet based on the determined first network coding mode. That is to say, the transmitting end only needs to send the corresponding encoded data to the first receiving end, and the first receiving end can effectively complete the decoding. Therefore, the delay caused by repeated sending of data packets can be avoided, and the reliability and throughput of data transmission can be improved while reducing physical resource overheads, thereby filling in the technical gap in related methods.

In an embodiment, because the type of the source data packet, the type of the first network coding mode, the type of the first network coding parameter, and the like have been described in detail in the above embodiments, and the difference between the above embodiments and this embodiment lies only in the execution entity, i.e., the above embodiments are executed by the transmitting end and this embodiment is executed by the first receiving end, related implementation in this embodiment correspond to those in the above embodiments. To avoid redundancy, the type of the source data packet, the type of the first network coding mode, the type of the first network coding parameter, and the like will not be described in detail again.

In an embodiment, when there is network coding in a plurality of Radio Interface Protocol stacks, the source data packets in any two of the Radio Interface Protocol stacks correspond to different first network coding modes. In other words, first network coding modes corresponding to source data packets in different Radio Interface Protocol stacks can be distinguished, so this characteristic can be used as a determination criterion to detect the source of a source data packet in the network space. For example, the Radio Interface Protocol stack to which the source data packet belongs can be further determined according to the source of the source data packet, which is not limited herein.

As shown in FIG. 33, in an embodiment of the present disclosure, S220 is further described, and S220 may include, but not limited to, the following steps S2201 to S2202.

At S2201, a second network coding mode for the first encoded data packet is determined according to a pre-configured second network coding parameter.

At S2202, the first encoded data packet is processed according to the second network coding mode.

In this step, the second network coding mode for the first encoded data packet is determined according to the pre-configured second network coding parameter, and the received first encoded data packet can be processed according to the second network coding mode, such that the first encoded data packet can be further used for data processing. This helps improve the reliability and throughput of data transmission.

In an embodiment of the present disclosure, S2202 is further described, and S2202 may include, but not limited to, at least one of:

sending the first encoded data packet to a second receiving end according to the second network coding mode;

decoding the first encoded data packet according to the second network coding mode to obtain the at least one source data packet;

encoding the first encoded data packet according to the second network coding mode to obtain a second encoded data packet, and sending the second encoded data packet to a second receiving end; or

decoding the first encoded data packet according to the second network coding mode to obtain the at least one source data packet, encoding the at least one source data packet to obtain a third encoded data packet, and sending the third encoded data packet to a second receiving end.

In this step, if the first encoded data packet is sent to the second receiving end according to the second network coding mode, forwarding of the first encoded data packet can be realized. That is to say, the first encoded data packet output from the transmitting end can be forwarded on a per-link basis as required, such that the first encoded data packet can be utilized. If the first encoded data packet is decoded according to the second network coding mode to obtain the source data packet, the decoding and restoration of the source data packet can be realized. If the first encoded data packet is encoded according to the second network coding mode to obtain the second encoded data packet and the second encoded data packet is sent to the second receiving end, second encoding can be realized. In this way, multiple times of encoding and forwarding of the encoded data are realized. If the first encoded data packet is decoded according to the second network coding mode to obtain the source data packet, the source data packet is encoded to obtain the third encoded data packet, and the third encoded data packet is sent to the second receiving end, the decoding and restoration of the source data packet can be realized, and second encoding can be performed based on the restored source data packet. This reflects the diversity of data encoding.

In an embodiment, the second network coding mode includes, but not limited to, at least one of:

LT coding;

Raptor coding;

Raptor Q coding;

RS coding;

LNC;

RLNC; or

FNC.

In an embodiment, the second network coding parameter includes, but not limited to, at least one of:

coding mode indication information;

a transmission direction of the source data packet;

quantity information of the source data packet;

size information of the source data packet;

quantity information of the first encoded data packet;

quantity information of a redundant data packet;

a code rate;

throughput;

reliability requirement;

an erasure rate;

an encoding matrix;

index information of the first encoded data packet;

layer information of a Radio Interface Protocol stack;

user type information;

channel state information;

an application scenario;

a network frequency range;

UE capability information; or

network bandwidth.

In an embodiment, implementations of the second network coding mode are similar to those of the first network coding mode, and implementations of the second network coding parameter are similar to those of the first network coding parameter, so reference can be made to the related descriptions in the above embodiments and the details will not be repeated here.

In an embodiment of the present disclosure, the data processing method may further include, but not limited to, the following steps S2100 to S2300.

At S2100, when at least one source data packet is acquired, a first network coding mode for the at least one source data packet is determined from a network coding mode set according to a pre-configured first network coding parameter.

At S2200, the at least one source data packet is encoded according to the first network coding mode to obtain a first encoded data packet.

At S2300, the first encoded data packet is sent to a first receiving end, such that the first receiving end processes the first encoded data packet.

In an embodiment, the manner in which the at least one source data packet is encoded according to the first network coding mode to obtain the first encoded data packet in S2200 is the same as that in S220.

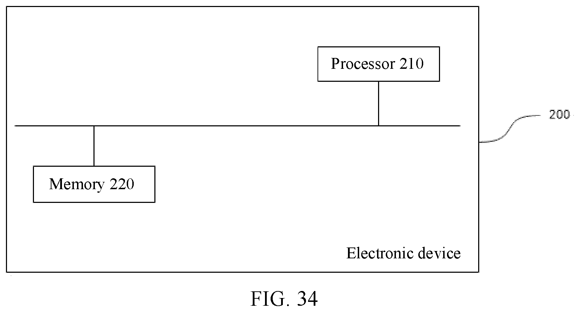

In an embodiment, S210, S220, and related steps have been described in detail in the above embodiments, and the difference between the above embodiments and this embodiment lies only in the network coding mode set in S2100, i.e., the network coding mode set in S2100 includes at least two of LT coding, Raptor coding, Raptor Q coding, RS coding, LNC, RLNC, and FNC. Therefore, related implementations in this embodiment correspond to those in the above embodiments. To avoid redundancy, specific implementations of S2100, S2200, and S2300 will not be described in detail again. In addition, as shown in FIG. 34, an embodiment of the present disclosure discloses an electronic device 200, including: at least one processor 210; and at least one memory 220, configured for storing at least one program, where the at least one program, when executed by the at least one processor 210, causes the at least one processor 210 to implement the data processing method according to any one of the above embodiments.

In addition, an embodiment of the present disclosure provides a computer-readable storage medium, storing computer-executable instructions which, when executed by a processor, causes the processor to implement the data processing method according to any of the above embodiments.

In addition, an embodiment of the present disclosure provides a computer program product, including a computer program or computer instructions stored in a computer-readable storage medium, where the computer program or the computer instructions, when read from the computer-readable storage medium and executed by a processor of a computer device, causes the computer device to implement the data processing method according to any of the above embodiments.

Those having ordinary skills in the art can understand that all or some of the steps in the methods disclosed above and the functional modules/units in the system and the apparatus can be implemented as software, firmware, hardware, and appropriate combinations thereof. Some or all physical components may be implemented as software executed by a processor, such as a central processing unit, a digital signal processor, or a microprocessor, or as hardware, or as an integrated circuit, such as an application-specific integrated circuit. Such software may be distributed on a computer-readable medium, which may include a computer storage medium (or non-transitory medium) and a communication medium (or transitory medium). As is known to those having ordinary skills in the art, the term "computer storage medium" includes volatile and nonvolatile, removable and non-removable media implemented in any method or technology for storage of information (such as computer-readable instructions, data structures, program modules, or other data). The computer storage medium includes, but not limited to, a Random Access Memory (RAM), a Read-Only Memory (ROM), an Electrically Erasable Programmable Read-Only Memory (EEPROM), a flash memory or other memory technology, a Compact Disc Read-Only Memory (CD-ROM), a Digital Versatile Disc (DVD) or other optical storage, a cassette, a magnetic tape, a magnetic disk storage or other magnetic storage device, or any other medium which can be used to store the desired information and can be accessed by a computer. In addition, as is known to those having ordinary skills in the art, the communication medium typically includes computer-readable instructions, data structures, program modules, or other data in a modulated data signal such as a carrier or other transport mechanism, and can include any information delivery medium.

**Claims**

1. A data processing method, comprising:

   determining, in response to acquiring at least one source data packet, a first network coding mode for the at least one source data packet according to a pre-configured first network coding parameter;
   encoding the at least one source data packet according to the first network coding mode to obtain a first encoded data packet; and
   sending the first encoded data packet to a first receiving end, such that the first receiving end processes the first encoded data packet.

2. The data processing method of claim 1, wherein the first network coding mode comprises at least one of:

   Luby Transform (LT) coding;
   Rapid Tornado (Raptor) coding;
   Raptor Q coding;
   Reed-Solomon (RS) coding;
   Linear Network Coding (LNC);
   Random Linear Network Coding (RLNC); or
   Fulcrum Network Coding (FNC).

3. The data processing method of claim 1, wherein the first network coding parameter comprises at least one of:

   coding mode indication information;
   a transmission direction of the source data packet;
   quantity information of the source data packet;
   size information of the source data packet;
   quantity information of the first encoded data packet;
   quantity information of a redundant data packet;
   a code rate;
   throughput;
   reliability requirement;
   an erasure rate;
   an encoding matrix;
   index information of the first encoded data packet;
   layer information of a Radio Interface Protocol stack;
   user type information;
   channel state information;
   an application scenario;
   a network frequency range;
   User Equipment (UE) capability information; or
   network bandwidth.

4. The data processing method of claim 1, wherein the source data packet comprises at least one of:

   a data packet of a Packet Data Convergence Protocol (PDCP) sublayer in a Radio Interface Protocol stack;
   a data packet of a Radio Link Control (RLC) sublayer in a Radio Interface Protocol stack;
   a data packet of a Media Access Control (MAC) sublayer in a Radio Interface Protocol stack; or
   a data packet of a physical layer in a Radio Interface Protocol stack.

5. The data processing method of claim 3, wherein in response to the first network coding parameter comprising the coding mode indication information, the coding mode indication information comprises at least one of:

first coding mode indication information for indicating whether to use a network coding mode;
second coding mode indication information for indicating to use at least one network coding mode; or
third coding mode indication information for indicating whether to use a network coding mode and indicating to use at least one network coding mode.

6. The data processing method of claim 3, wherein in response to the first network coding parameter comprising the transmission direction of the source data packet, determining a first network coding mode according to a pre-configured first network coding parameter comprises at least one of:

determining RS coding as the first network coding mode in response to the transmission direction of the source data packet being an uplink transmission direction; or
determining Raptor Q coding as the first network coding mode in response to the transmission direction of the source data packet being a downlink transmission direction.

7. The data processing method of claim 3, wherein in response to the first network coding parameter comprising the application scenario, determining a first network coding mode according to a pre-configured first network coding parameter comprises at least one of:

determining RS coding as the first network coding mode in response to the application scenario being Ultra Reliable Low Latency Communication (URLLC);
determining Raptor Q coding as the first network coding mode in response to the application scenario being Enhanced Mobile Broadband (eMBB); or
determining FNC as the first network coding mode in response to the application scenario being Massive Machine Type Communications (mMTC).

8. The data processing method of claim 3, wherein in response to the first network coding parameter comprising the network frequency range, determining a first network coding mode according to a pre-configured first network coding parameter comprises at least one of:

in response to the network frequency range comprising a first network frequency range and a second network frequency range, determining RS coding as the first network coding mode within the first network frequency range and determining Raptor Q coding as the first network coding mode within the second network frequency range, wherein frequencies in the first network frequency range are lower than frequencies in the second network frequency range; or
in response to the network frequency range comprising a first network frequency range and a second network frequency range, determining RS coding as the first network coding mode within the first network frequency range and determining FNC as the first network coding mode within the second network frequency range, wherein frequencies in the first network frequency range are lower than frequencies in the second network frequency range.

9. The data processing method of claim 3, wherein in response to the first network coding parameter comprising the UE capability information, determining a first network coding mode according to a pre-configured first network coding parameter comprises at least one of:

determining Raptor Q coding as the first network coding mode in response to the UE capability information comprising a maximum number of antennas supported and the maximum number of antennas supported being greater than a first threshold, wherein the first threshold is one of 4, 6, 8, 12, or 16;
determining RS coding as the first network coding mode in response to the UE capability information comprising a maximum number of antennas supported and the maximum number of antennas supported being not greater than a first threshold, wherein the first threshold is one of 4, 6, 8, 12, or 16;
determining Raptor Q coding as the first network coding mode in response to the UE capability information comprising a maximum modulation order supported and the maximum modulation order supported being greater than a second threshold, wherein the second threshold is one of 4, 6, 8, or 10;
determining RS coding as the first network coding mode in response to the UE capability information comprising a maximum modulation order supported and the maximum modulation order supported being not greater than a second threshold, wherein the second threshold is one of 4, 6, 8, or 10;

determining Raptor Q coding as the first network coding mode in response to the UE capability information comprising a maximum data rate supported and the maximum data rate supported being greater than a third threshold, wherein the third threshold is one of 500 Mbps, 1 Gbps, or 10 Gbps; or

determining RS coding as the first network coding mode in response to the UE capability information comprising a maximum data rate supported and the maximum data rate supported being not greater than a third threshold, wherein the third threshold is one of 500 Mbps, 1 Gbps, or 10 Gbps.

10. The data processing method of claim 3, wherein in response to the first network coding parameter comprising the network bandwidth, determining a first network coding mode according to a pre-configured first network coding parameter comprises at least one of:

determining LT coding as the first network coding mode in response to the network bandwidth being configured to be a first network bandwidth;

determining Raptor Q coding as the first network coding mode in response to the network bandwidth being configured to be a second network bandwidth;

determining RS coding as the first network coding mode in response to the network bandwidth being configured to be a third network bandwidth; or

determining FNC as the first network coding mode in response to the network bandwidth being configured to be a fourth network bandwidth.

11. The data processing method of claim 3, wherein in response to the first network coding parameter comprising the quantity information of the source data packet, determining a first network coding mode according to a pre-configured first network coding parameter comprises:

in response to determining a first mapping relationship between at least two preset network coding modes and the quantity information of the source data packet, selecting the first network coding mode from the preset network coding modes according to the quantity information of the source data packet and the first mapping relationship, wherein the first mapping relationship is used to characterize a quantity of the source data packets supported by each of the preset network coding modes.

12. The data processing method of claim 3, wherein in response to the first network coding parameter comprising the size information of the source data packet, determining a first network coding mode according to a pre-configured first network coding parameter comprises:

in response to determining a second mapping relationship between at least two preset network coding modes and the size information of the source data packet, selecting the first network coding mode from the preset network coding modes according to the size information of the source data packet and the second mapping relationship, wherein the second mapping relationship is used to characterize a size of the source data packet supported by each of the preset network coding modes.

13. The data processing method of claim 3, wherein in response to the first network coding parameter comprising the quantity information of the first encoded data packet, determining a first network coding mode according to a pre-configured first network coding parameter comprises:

in response to determining a third mapping relationship between at least two preset network coding modes and the quantity information of the first encoded data packet, selecting the first network coding mode from the preset network coding modes according to the quantity information of the first encoded data packet and the third mapping relationship, wherein the third mapping relationship is used to characterize a quantity of first encoded data packets supported by each of the preset network coding modes.

14. The data processing method of claim 3, wherein in response to the first network coding parameter comprising the quantity information of the redundant data packet, determining a first network coding mode according to a pre-configured first network coding parameter comprises:

in response to determining a fourth mapping relationship between at least two preset network coding modes and the quantity information of the redundant data packet, selecting the first network coding mode from the preset network coding modes according to the quantity information of the redundant data packet and the fourth mapping relationship, wherein the fourth mapping relationship is used to characterize a quantity of redundant data packets supported by each of the preset network coding modes.

15. The data processing method of claim 3, wherein in response to the first network coding parameter comprising the code rate, determining a first network coding mode according to a pre-configured first network coding parameter comprises:

EP 4 529 057 A1

in response to determining a fifth mapping relationship between at least two preset network coding modes and the code rate, selecting the first network coding mode from the preset network coding modes according to the code rate and the fifth mapping relationship, wherein the fifth mapping relationship is used to characterize the code rate supported by each of the preset network coding modes.

16. The data processing method of claim 3, wherein in response to the first network coding parameter comprising the code rate and the quantity information of the source data packet, determining a first network coding mode according to a pre-configured first network coding parameter comprises at least one of:

in response to determining a sixth mapping relationship between at least two network coding mode subsets and the code rate, selecting a target network coding mode subset from the network coding mode subsets according to the code rate and the sixth mapping relationship, and selecting a preset network coding mode from the target network coding mode subset as the first network coding mode according to the quantity information of the source data packet, wherein the sixth mapping relationship is used to characterize a range of the code rate supported by each of the network coding mode subsets, and each of the network coding mode subsets comprises a plurality of preset network coding modes; or
in response to determining a seventh mapping relationship between at least two preset network coding modes, the code rate, and the quantity information of the source data packet, selecting the first network coding mode from the preset network coding modes according to the code rate, the quantity information of the source data packet, and the seventh mapping relationship, wherein the seventh mapping relationship is used to characterize a range of the code rate and a range of a quantity of source data packets that are supported by each of the preset network coding modes.

17. The data processing method of claim 3, wherein in response to the first network coding parameter comprising the throughput, determining a first network coding mode according to a pre-configured first network coding parameter comprises:
in response to determining an eighth mapping relationship between at least two preset network coding modes and the throughput, selecting the first network coding mode from the preset network coding modes according to the throughput and the eighth mapping relationship, wherein the eighth mapping relationship is used to characterize the throughput supported by each of the preset network coding modes.

18. The data processing method of claim 3, wherein in response to the first network coding parameter comprising the reliability requirement, determining a first network coding mode according to a pre-configured first network coding parameter comprises:
in response to determining a ninth mapping relationship between at least two preset network coding modes and the reliability requirement, selecting the first network coding mode from the preset network coding modes according to the reliability requirement and the ninth mapping relationship, wherein the ninth mapping relationship is used to characterize the reliability requirement supported by each of the preset network coding modes.

19. The data processing method of claim 3, wherein in response to the first network coding parameter comprising the erasure rate, determining a first network coding mode according to a pre-configured first network coding parameter comprises:
in response to determining a tenth mapping relationship between at least two preset network coding modes and the erasure rate, selecting the first network coding mode from the preset network coding modes according to the erasure rate and the tenth mapping relationship, wherein the tenth mapping relationship is used to characterize the erasure rate supported by each of the preset network coding modes.

20. The data processing method of claim 3, wherein in response to the first network coding parameter comprising the size information of the source data packet and the quantity information of the source data packet, determining a first network coding mode according to a pre-configured first network coding parameter comprises:
in response to determining an eleventh mapping relationship between at least two preset network coding modes, the size information of the source data packet, and the quantity information of the source data packet, selecting the first network coding mode from the preset network coding modes according to the size information of the source data packet, the quantity information of the source data packet, and the eleventh mapping relationship, wherein the eleventh mapping relationship is used to characterize a range of a size of the source data packet and a range of a quantity of source data packets that are supported by each of the preset network coding modes.

21. The data processing method of claim 3, wherein in response to the first network coding parameter comprising the quantity information of the redundant data packet and the reliability requirement, determining a first network coding mode according to a pre-configured first network coding parameter comprises:

in response to determining a twelfth mapping relationship between at least two preset network coding modes, the quantity information of the redundant data packet, and the reliability requirement, selecting the first network coding mode from the preset network coding modes according to the quantity information of the redundant data packet, the reliability requirement, and the twelfth mapping relationship, wherein the twelfth mapping relationship is used to characterize a quantity of redundant data packets and the reliability requirement that are supported by each of the preset network coding modes.

22. The data processing method of claim 3, wherein in response to the first network coding parameter comprising the code rate, the quantity information of the source data packet, and the reliability requirement, determining a first network coding mode according to a pre-configured first network coding parameter comprises:

in response to determining a sixth mapping relationship between at least two network coding mode subsets and the code rate, selecting a target network coding mode subset from the network coding mode subsets according to the code rate and the sixth mapping relationship, wherein the sixth mapping relationship is used to characterize a range of the code rate supported by each of the network coding mode subsets, and each of the network coding mode subsets comprises a plurality of preset network coding modes; and
selecting a preset network coding mode from the target network coding mode subset as the first network coding mode according to the quantity information of the source data packet and the reliability requirement.

23. The data processing method of claim 3, wherein in response to the first network coding parameter comprising the channel state information, determining a first network coding mode according to a pre-configured first network coding parameter comprises at least one of:

in response to the channel state information comprising channel quality indication information, determining the first network coding mode according to an index value of the channel quality indication information;
in response to the channel state information comprising rank indication information, determining the first network coding mode according to a value of the rank indication information; or
in response to the channel state information comprising precoding matrix indication information, determining the first network coding mode according to an index value of the precoding matrix indication information.

24. The data processing method of claim 1, wherein prior to determining a first network coding mode according to a pre-configured first network coding parameter, the data processing method comprises at least one of:

acquiring the pre-configured first network coding parameter sent through high-layer signaling; or
acquiring the pre-configured first network coding parameter sent through header information of the source data packet.

25. The data processing method of claim 4, wherein in response to existence of network coding in a plurality of Radio Interface Protocol stacks, the source data packets in any two of the Radio Interface Protocol stacks correspond to different first network coding modes.

26. A data processing method, comprising:

receiving a first encoded data packet sent by a transmitting end, wherein the first encoded data packet is obtained by the transmitting end by encoding acquired at least one source data packet according to a first network coding mode for the source data packet, and the first network coding mode is determined by the transmitting end according to a pre-configured first network coding parameter; and
processing the first encoded data packet.

27. The data processing method of claim 26, wherein the first network coding mode comprises at least one of:

Luby Transform (LT) coding;
Rapid Tornado (Raptor) coding;
Raptor Q coding;
Reed-Solomon (RS) coding;
Linear Network Coding (LNC);

Random Linear Network Coding (RLNC); or
Fulcrum Network Coding (FNC).

28. The data processing method of claim 26, wherein the first network coding parameter comprises at least one of:

coding mode indication information;
a transmission direction of the source data packet;
quantity information of the source data packet;
size information of the source data packet;
quantity information of the first encoded data packet;
quantity information of a redundant data packet;
a code rate;
throughput;
reliability requirement;
an erasure rate;
an encoding matrix;
index information of the first encoded data packet;
layer information of a Radio Interface Protocol stack;
user type information;
channel state information;
an application scenario;
a network frequency range;
User Equipment (UE) capability information; or
network bandwidth.

29. The data processing method of claim 26, wherein the source data packet comprises at least one of:

a data packet of a Packet Data Convergence Protocol (PDCP) sublayer in a Radio Interface Protocol stack;
a data packet of a Radio Link Control (RLC) sublayer in a Radio Interface Protocol stack;
a data packet of a Media Access Control (MAC) sublayer in a Radio Interface Protocol stack; or
a data packet of a physical layer in a Radio Interface Protocol stack.

30. The data processing method of claim 26, wherein processing the first encoded data packet comprises:

determining a second network coding mode for the first encoded data packet according to a pre-configured second network coding parameter; and
processing the first encoded data packet according to the second network coding mode.

31. The data processing method of claim 30, wherein processing the first encoded data packet according to the second network coding mode comprises at least one of:

sending the first encoded data packet to a second receiving end according to the second network coding mode;
decoding the first encoded data packet according to the second network coding mode to obtain the at least one source data packet;
encoding the first encoded data packet according to the second network coding mode to obtain a second encoded data packet, and sending the second encoded data packet to a second receiving end; or
decoding the first encoded data packet according to the second network coding mode to obtain the at least one source data packet, encoding the at least one source data packet to obtain a third encoded data packet, and sending the third encoded data packet to a second receiving end.

32. The data processing method of claim 30 or 31, wherein the second network coding mode comprises at least one of:

LT coding;
Raptor coding;
Raptor Q coding;
RS coding;
LNC;
RLNC; or

FNC.

33. The data processing method of claim 30, wherein the second network coding parameter comprises at least one of:

coding mode indication information;
a transmission direction of the source data packet;
quantity information of the source data packet;
size information of the source data packet;
quantity information of the first encoded data packet;
quantity information of a redundant data packet;
a code rate;
throughput;
reliability requirement;
an erasure rate;
an encoding matrix;
index information of the first encoded data packet;
layer information of a Radio Interface Protocol stack;
user type information;
channel state information;
an application scenario;
a network frequency range;
UE capability information; or
network bandwidth.

34. The data processing method of claim 29, wherein in response to existence of network coding in a plurality of Radio Interface Protocol stacks, the source data packets in any two of the Radio Interface Protocol stacks correspond to different first network coding modes.

35. An electronic device, comprising:

at least one processor; and
at least one memory, configured for storing at least one program,
wherein the at least one program, when executed by the at least one processor, causes the at least one processor to perform the data processing method of any one of claims 1 to 34.

36. A computer-readable storage medium, storing a processor-executable program which, when executed by a processor, causes the processor to perform the data processing method of any one of claims 1 to 34.

First encoded data
packet

120

110

FIG. 1

First encoded data
packet

120

130

110

FIG. 2

| Determine, when at least one source data packet is acquired, a first network coding mode for the at least one source data packet according to a pre-configured first network coding parameter | S110 |

| Encode the at least one source data packet according to the first network coding mode to obtain a first encoded data packet | S120 |

| Send the first encoded data packet to a first receiving end, such that the first receiving end processes the first encoded data packet | S130 |

FIG. 3

| Randomly generate a degree of one of the first encoded data packets according to a first degree distribution and the first random seed | S1200 |

| Select a target quantity of source data packets from the source data packets based on the second random seed | S1201 |

| Perform encoding computation on the target quantity of source data packets and encoding matrices corresponding to the target quantity of source data packets to obtain a first encoded data packet | S1202 |

FIG. 4

FIG. 5

| Pre-code the source data packets according to a second degree distribution and the third random seed to obtain intermediate encoded data packets | S1203 |

| Encode the intermediate encoded data packet by LT coding according to a third degree distribution and the fourth random seed to obtain the first encoded data packet | S1204 |

FIG. 6

Precoding matrix ⌐ 308

$$
n0=7 \left\{
\begin{array}{ccccc}
1 & 0 & 0 & 0 & 0 \\
0 & 1 & 0 & 0 & 0 \\
0 & 0 & 1 & 0 & 0 \\
0 & 0 & 0 & 1 & 0 \\
0 & 0 & 0 & 0 & 1 \\
1 & 0 & 1 & 1 & 0 \\
0 & 1 & 0 & 1 & 1
\end{array}
\right.
$$

k=5

$D_0$  $D_1$  $S_2$  $S_3$  $S_4$  ⌐ 302

Precoding

⌐ 304

LT coding

⌐ 306

LT encoding matrix ⌐ 310

$R_0$  $R_1$  $R_2$  $R_3$  $R_4$  $R_5$  $R_6$  $R_7$

☐ Source data packet

▨ Intermediate encoded data packet

○ First encoded data packet

$$
n=8 \left\{
\begin{array}{ccccccc}
0 & 1 & 0 & 0 & 1 & 0 & 0 \\
1 & 0 & 1 & 0 & 0 & 0 & 0 \\
0 & 0 & 0 & 0 & 0 & 1 & 0 \\
0 & 0 & 0 & 1 & 0 & 0 & 1 \\
0 & 0 & 1 & 0 & 0 & 0 & 0 \\
0 & 1 & 0 & 1 & 0 & 0 & 0 \\
0 & 0 & 0 & 0 & 1 & 0 & 1 \\
1 & 0 & 0 & 0 & 0 & 1 & 0
\end{array}
\right.
$$

n0=7

FIG. 7

402                404

|       | B          | S     | U | H            |
|-------|------------|-------|---|--------------|
| S     | $G_{LDPC1}$ | $I_S$ |   | $G_{LDPC2}$  |
| H     | $G_{HDPC}$ |       |   | $I_H$        |
| K'    | $G_{LT}$   |       |   |              |

$IS_0$

$\begin{array}{c} 0 \\ . \\ . \\ . \\ 0 \\ D_0 \\ ... \\ D_{k-1} \\ 0 \\ ... \\ 0 \end{array}$

S+H zero ⌐ 406A

Extended Source Symbols ⌐ 406B

$IS_{L-1}$

$$\mathbf{G} \qquad \mathbf{I} \qquad \mathbf{D'}$$

FIG. 8

FIG. 9

FIG. 10

Randomly select elements from the finite field based on the sixth random seed to obtain an encoding matrix — S1207

Perform matrix calculation on the encoding matrix and the source data packets to obtain the first encoded data packet — S1208

FIG. 11

$$
\overbrace{\begin{array}{|c|c|c|c|}
\hline
g_{0,0} & g_{0,1} & \cdots & g_{0,k-1} \\
\hline
g_{1,0} & g_{1,1} & \cdots & g_{1,k-1} \\
\hline
\cdots & \cdots & \cdots & \cdots \\
\hline
g_{n-1,0} & g_{n-1,1} & \cdots & g_{n-1,k-1} \\
\hline
\end{array}}^{k \quad 702}
\bullet
\begin{array}{|c|}
\hline
D_0 \\
\hline
D_1 \\
\hline
\cdots \\
\hline
D_{k-1} \\
\hline
\end{array}
=
\begin{array}{|c|}
\hline
R_0 \\
\hline
R_1 \\
\hline
\cdots \\
\hline
R_{n-1} \\
\hline
\end{array}
$$

$n$

704   706

G          D          R

FIG. 12

Randomly select elements from the finite field based on a seventh random seed to obtain a first encoding matrix, and randomly select elements from the finite field based on an eighth random seed to obtain a second encoding matrix — S1209

Obtain the first encoded data packet according to the first encoding matrix and the second encoding matrix — S1210

FIG. 13

**Outer encoding**

802A, 802B

$$G1 \cdot D = O$$

| 1 | 0 | ... | 0 |
|---|---|-----|---|
| 0 | 1 | ... | 0 |
| ... | ... | ... | ... |
| 0 | 0 | 0 | 1 |
| $g'_{0,0}$ | $g'_{0,1}$ | ... | $g'_{0,k-1}$ |
| ... | ... | ... | ... |
| $g'_{n-1,0}$ | $g'_{n-1,1}$ | ... | $g'_{n-1,k-1}$ |

**G1**

$$D = \begin{bmatrix} D_0 \\ D_1 \\ ... \\ D_{k-1} \end{bmatrix}$$

$$O = \begin{bmatrix} D_0 \\ D_1 \\ ... \\ D_{k-1} \\ O_0 \\ ... \\ O_{n-1} \end{bmatrix}$$

**Inner encoding**

| $g_{0,0}$ | $g_{0,1}$ | ... | $g_{0,n-1}$ |
|-----------|-----------|-----|-------------|
| $g_{1,0}$ | $g_{1,1}$ | ... | $g_{1,n-1}$ |
| ... | ... | ... | ... |
| $g_{n-1,0}$ | $g_{n-1,1}$ | ... | $g_{n-1,n-1}$ |

**G2** $\cdot O = $ **R**

$$R = \begin{bmatrix} R_0 \\ R_1 \\ ... \\ R_{n-1} \end{bmatrix}$$

FIG. 14

902 904 906 908

| Area 1 (RLNC) | Area 2 (FNC) | Area 3 (RS) | Area 4 (RaptorQ) |

0    $2^4$    $2^6$    $2^8$    k

FIG. 15

1002 1004 1006 1008

| Area 1 (RLNC) | Area 2 (FNC) | Area 3 (RaptorQ) | Area 4 (RS) |

0    1/4    1/2    3/4    R

FIG. 16

FIG. 17

FIG. 18

FIG. 19

FIG. 20

FIG. 21

| When a sixth mapping relationship between at least two network coding mode subsets and the code rate is determined, select a target network coding mode subset from the network coding mode subsets according to the code rate and the sixth mapping relationship | S1111 |

| Select a preset network coding mode from the target network coding mode subset as the first network coding mode according to the quantity information of the source data packet and the reliability requirement | S1112 |

FIG. 22

FIG. 23

FIG. 24

FIG. 25

FIG. 26

FIG. 27

FIG. 28

FIG. 29

FIG. 30

FIG. 31

FIG. 32

Receive a first encoded data packet sent by a transmitting end — S210

Process the first encoded data packet — S220

FIG. 32

Determine a second network coding mode for the first encoded data packet according to a pre-configured second network coding parameter — S2201

Process the first encoded data packet according to the second network coding mode — S2202

FIG. 33

FIG. 34

## INTERNATIONAL SEARCH REPORT

| | International application No. |
|---|---|
| | **PCT/CN2023/089309** |

**A. CLASSIFICATION OF SUBJECT MATTER**

H04L1/00(2006.01)i

According to International Patent Classification (IPC) or to both national classification and IPC

**B. FIELDS SEARCHED**

Minimum documentation searched (classification system followed by classification symbols)

IPC: H04L

Documentation searched other than minimum documentation to the extent that such documents are included in the fields searched

Electronic data base consulted during the international search (name of data base and, where practicable, search terms used)

CNTXT; CNABS; CNKI; VEN; WOTXT; USTXT; EPTXT: 赵巍, 许进, 李立广, 梁楚龙, 薛妍, 谢峰, 中兴, 编码, 参数, 系数, 方式, 方案, 网络编码, 指示, 传输方向, 上行, 下行, 数据包, 数量, 大小, 码率, 吞吐量, 可靠性, 擦除率, 索引, 带宽, network code, parameter, coefficient, method, indication, data package, data packet, size, quantity, rate, throughout, index

**C. DOCUMENTS CONSIDERED TO BE RELEVANT**

| Category* | Citation of document, with indication, where appropriate, of the relevant passages | Relevant to claim No. |
|---|---|---|
| PX | CN 114598333 A (HUAWEI TECHNOLOGIES CO., LTD.) 07 June 2022 (2022-06-07) claims 43-45, description, paragraphs [0077] and [0081]-[0190], and figure 3 | 1-36 |
| X | CN 113746592 A (HUAWEI TECHNOLOGIES CO., LTD.) 03 December 2021 (2021-12-03) description, paragraphs [0078]-[0089] and [0115]-[0169], and figure 3 | 1-36 |
| X | CN 113472480 A (VIVO COMMUNICATION TECHNOLOGY CO., LTD.) 01 October 2021 (2021-10-01) claims 38 and 39, description, paragraphs [0056]-[0259], and figures 1 and 2 | 1-36 |
| A | WO 2022000230 A1 (QUALCOMM INC. et al.) 06 January 2022 (2022-01-06) entire document | 1-36 |

☐ Further documents are listed in the continuation of Box C.    ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **25 July 2023** | **26 July 2023** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

INTERNATIONAL SEARCH REPORT
**Information on patent family members**

International application No.

**PCT/CN2023/089309**

| Patent document cited in search report | | | Publication date (day/month/year) | Patent family member(s) | | | Publication date (day/month/year) |
|---|---|---|---|---|---|---|---|
| CN | 114598333 | A | 07 June 2022 | WO | 2022116946 | A1 | 09 June 2022 |
| CN | 113746592 | A | 03 December 2021 | WO | 2021238676 | A1 | 02 December 2021 |
| CN | 113472480 | A | 01 October 2021 | WO | 2021197153 | A1 | 07 October 2021 |
| WO | 2022000230 | A1 | 06 January 2022 | None | | | |

Form PCT/ISA/210 (patent family annex) (July 2022)

**EP 4 529 057 A1**

**Patent documents cited in the description**

- CN 202210550053